(19) Europäisches Patentamt
European Patent Office
Office européen des brevets

(11) Veröffentlichungsnummer: **0 269 573 B1**

(12) # EUROPÄISCHE PATENTSCHRIFT

(45) Veröffentlichungstag der Patentschrift: **27.03.91**

(51) Int. Cl.5: **C08F 2/50**, G03F 7/031, G03F 7/004

(21) Anmeldenummer: **87810684.8**

(22) Anmeldetag: **20.11.87**

(54) **Flüssige Photoinitiatorgemische.**

(30) Priorität: **26.11.86 CH 4734/86**
**05.02.87 CH 416/87**

(43) Veröffentlichungstag der Anmeldung:
**01.06.88 Patentblatt 88/22**

(45) Bekanntmachung des Hinweises auf die Patenterteilung:
**27.03.91 Patentblatt 91/13**

(84) Benannte Vertragsstaaten:
**AT BE CH DE ES FR GB IT LI NL SE**

(56) Entgegenhaltungen:
**EP-A- 0 122 223**
**EP-A- 0 242 330**
**US-A- 4 559 371**

(73) Patentinhaber: **CIBA-GEIGY AG**
**Klybeckstrasse 141**
**CH-4002 Basel(CH)**

(72) Erfinder: **Hüsler, Rinaldo, Dr.**
**Route du Confin 52**
**CH-1723 Marly(CH)**
Erfinder: **Rutsch, Werner, Dr.**
**Avenue Weck-Reynold 1**
**CH-1700 Fribourg(CH)**
Erfinder: **Rembold, Manfred, Dr.**
**Im Aeschfeld 21**
**CH-4147 Aesch(CH)**
Erfinder: **Sitek, Franciszek, Dr.**
**Grossmattweg 11**
**CH-4106 Therwil(CH)**

**EP 0 269 573 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft flüssige Gemische von Photoinitiatoren. Es handelt sich dabei um Lösungen von Titanocenverbindungen in flüssigen Photoinitiatoren vom Type der α-Hydroxy- und α-Aminoacetophenonderivate. Die Erfindung betrifft weiterhin photohärtbare Zusammensetzungen, die solche flüssige Photoinitiatorgemische enthalten.

Titanocenverbindungen mit fluoraromatischen Resten sind aus der EP-A-122.223 als sehr wirksame Initiatoren für die Photopolymerisation ethylenisch ungesättigter Verbindungen bekannt. Die dort beschriebenen Verbindungen sind meist fest und in den üblichen photopolymerisierbaren Verbindungen bzw. Gemischen schwer löslich. Es besteht ein Bedarf an leicht löslichen oder flüssigen Photoinitiatoren mit hoher Wirksamkeit. Es wurde nun gefunden, dass eine Kombination von Titanocen-Initiatoren mit flüssigen Photoinitiatoren vom Type der α-Hydroxy- oder α-Aminoacetophenone zu flüssigen Initiatorgemischen mit ausserordentlich hoher Wirksamkeit führt.

Photoinitiatoren vom Type der α-Hydroxy- und α-Aminoacetophenonderivate sind bekannt, z.B. aus US-A-4,347,111, US-A-4,318,791, US-A-4,559,371, US-A-4,582,862 oder EP-A-138,754. Unter den dort beschriebenen Verbindungen finden sich sowohl feste wie flüssige Verbindungen. Die flüssigen Verbindungen können erfindungsgemäss allein verwendet werden, die festen Verbindungen nur in einem flüssigen Gemisch mit anderen Photoinitiatoren.

Die Erfindung betrifft daher ein flüssiges Photoinitiatorgemisch, bestehend aus

A) 70-99,9 Gew.-% mindestens eines flüssigen Photoinitiators der Formel I oder eines flüssigen Gemisches aus metallfreien Photoinitiatoren enthaltend mindestens eine Verbindung der Formel I,

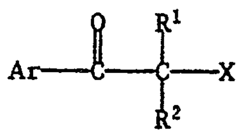

(I)

worin Ar eine unsubstituierte oder durch einen oder mehrere der Substituenten Halogen, $C_1$-$C_{18}$-Alkyl, $C_3$-$C_{12}$-Alkenyl, $C_1$-$C_{12}$-Alkoxy, Allyloxy, Phenoxy, $C_1$-$C_{18}$-Alkylthio, Allylthio, 2-Hydroxyethylthio, Phenylthio, Tolylthio, $C_1$-$C_{12}$-Alkylamino, $C_2$-$C_{24}$-Dialkylamino, $C_4$-$C_8$-Bis(hydroxyalkyl)amino, Diallylamino, Bis(2-methoxyethyl)amino, Morpholino, Piperidino oder Pyrrolidino substituierte Phenylgruppe bedeutet,

$R^1$ und $R^2$ unabhängig voneinander $C_1$-$C_{18}$-Alkyl oder durch -OH, $C_1$-$C_4$-Alkoxy, Benzyloxy, -CN, -COO($C_1$-$C_8$-Alkyl), ($C_1$-$C_4$-Alkyl)-COO-, $C_2$-$C_8$-Dialkylamino oder Morpholino substituiertes $C_1$-$C_4$-Alkyl bedeuten oder $R^1$ und $R^2$ zusammen $C_3$-$C_9$-Alkandiyl, $C_3$-$C_9$-Oxa- oder Azaalkandiyl oder $C_5$-$C_9$-Alkendiyl bedeuten,

X eine Gruppe $-OR^3$ oder $-NR^4R^5$ bedeutet, worin

$R^3$ Wasserstoff, $C_1$-$C_8$-Alkyl, durch Halogen, -OH oder $C_1$-$C_4$-Alkoxy substituiertes $C_2$-$C_4$-Alkyl, Allyl, Benzyl, 2-Tetrahydropyranyl, Trimethylsilyl oder Phenyl-dimethylsilyl bedeutet,

$R^4$ und $R^5$ unabhängig voneinander Wasserstoff, $C_1$-$C_{12}$-Alkyl, durch -OH, $C_1$-$C_4$-Alkoxy-, -CN oder -COO($C_1$-$C_4$-Alkyl) substituiertes $C_2$-$C_4$-Alkyl, Allyl, Benzyl oder Cyclohexyl bedeuten oder $R^4$ und $R^5$ zusammen $C_3$-$C_7$-Alkylen, das durch -O- oder $-N(R^6)-$ unterbrochen sein kann, bedeuten, worin $R^6$ Wasserstoff, $C_1$-$C_4$-Alkyl, Allyl, Benzyl oder $C_2$-$C_4$-Hydroxyalkyl bedeutet, und

B) 0,1-30 Gew.-% mindestens eines Titanocen-Photoinitiators, ausgewählt aus

$B_1$) Verbindungen der Formel II

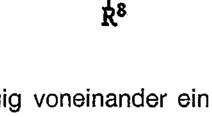

(II)

worin $R^7$ und $R^8$ unabhängig voneinander ein unsubstituiertes oder durch $C_1$-$C_4$-Alkyl, Chlor, Phenyl oder Cyclohexyl substituiertes Cyclopentadienyl- oder Indenyl-Anion bedeuten oder $R^7$ und $R^8$ zusammen ein zweiwertiges Bis-cyclopentadienyl-Anion der Formel III bedeuten,

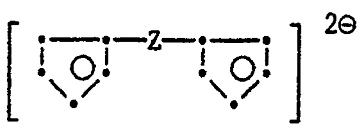

(III)

worin Z Methylen, Di- oder Trimethylen, $C_2$-$C_{12}$-Alkyliden, $C_5$-$C_7$-Cycloalkyliden, -Si($R^{11}$)($R^{12}$)- oder -Sn-($R^{11}$)$_2$- bedeutet und

$R^{11}$ und $R^{12}$ $C_1$-$C_{12}$-Alkyl, Phenyl oder Benzyl bedeuten,

$R^9$ den einwertigen Rest eines 6-gliedrigen carbocyclischen oder 5-oder 6-gliedrigen heterocyclischen aromatischen Ringes bedeutet, der in mindestens einer ortho-Position zur Bindung an das Ti-Atom durch Fluor substituiert ist und ausserdem durch eine oder mehrere der Substituenten Halogen, $C_1$-$C_{12}$-Alkyl, $C_1$-$C_{14}$-Alkoxy, $-O(CH_2CH_2O)_{1-20}$ $C_1$-$C_{14}$-Alkyl, $C_2$-$C_{10}$-Alkoxycarbonyl, Aminocarbonyl mit bis zu 12 C-Atomen oder durch eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen substituiert sein kann,

$R^{10}$ eine der für $R^9$ angegebenen Bedeutungen hat oder $C_2$-$C_{12}$-Alkinyl, unsubstituiertes oder im Phenylrest durch Halogen oder $C_1$-$C_{14}$-Alkyl substituiertes Phenylalkinyl mit 2 - 5 C-Atomen im Alkinrest oder Halogen oder eine Gruppe -Si($R^{11}$)$_3$, -Si($R^{11}$)$_2$($R^{12}$), -Sn($R^{11}$)$_3$, OH, $C_1$-$C_{10}$-Alkoxy, $C_6$-$C_{10}$-Aryloxy, unsubstituiertes oder durch Halogen substituiertes $C_2$-$C_6$-Acyloxy, $-N_3$, -CN, -NCO oder NCS bedeutet, oder

$R^9$ und $R^{10}$ zusammen einen Rest der Formel -Q-Y-Q- bedeuten, worin Q ein carbocyclischer oder 5- oder 6-gliedriger heterocyclischer aromatischer Ring ist, der in 2-Stellung zur Y-Gruppe an das Titan-Atom gebunden ist und in 3-Stellung durch Fluor substituiert ist und als weitere Substituenten $C_1$-$C_4$-Alkyl, Halogen, $C_1$-$C_4$-Alkoxy, Di($C_1$-$C_4$-alkyl)amino oder eine quartäre $C_3$-$C_{20}$-Ammoniumgruppe enthalten kann,

Y Methylen, $C_2$-$C_{12}$-Alkyliden, $C_5$-$C_7$-Cycloalkyliden, eine direkte Bindung oder eine Gruppe -N$R^{13}$-, -O-, -S-, -SO-, $-SO_2$-, -CO-, -Si($R^{11}$)($R^{12}$)- oder -Sn($R^{11}$)$_2$- bedeutet und $R^{13}$ Wasserstoff, $C_1$-$C_{12}$-Alkyl, Cyclohexyl, Phenyl, Tolyl oder Benzyl bedeutet, oder

$B_2$) Verbindungen der Formel IV,

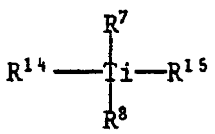

(IV)

worin $R^7$ und $R^8$ die oben genannte Bedeutung haben,

$R^{14}$ den einwertigen Rest eines 6-gliedrigen carbocyclischen oder 5-oder 6-gliedrigen heterocyclischen aromatischen Ringes bedeutet, der in mindestens einer ortho-Position zur Bindung an das Ti-Atom durch $-CF_3$ substituiert ist und ausserdem durch eine oder mehrere der Gruppen Halogen, $C_1$-$C_{12}$-Alkyl, $C_1$-$C_{14}$-Alkoxy, $-O(CH_2CH_2O)_{1-20}$ $C_1$-$C_{14}$-Alkyl,$C_2$-$C_{10}$-Alkoxycarbonyl oder Aminocarbonyl oder durch eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen substituiert sein kann, und

$R^{15}$ eine der für $R^{14}$ gegebenen Bedeutungen hat oder $C_2$-$C_{12}$-Alkinyl, unsubstituiertes oder im Phenylrest durch Halogen oder $C_1$-$C_4$-Alkyl substituiertes Phenylalkinyl mit 2 - 5 C-Atomen im Alkinrest oder Halogen oder eine Gruppe -Si($R^{11}$)$_3$, -Si($R^{11}$)$_2$($R^{12}$), -Sn($R^{11}$)$_3$, -OH, $C_1$-$C_{10}$-Alkoxy, $C_6$-$C_{10}$-Aryloxy, unsubstituiertes oder mit Halogen substituiertes $C_2$-$C_6$-Acyloxy, $-N_3$, -CN, -NCO oder -NCS bedeutet.

Wenn in Formel I Ar eine substituierte Phenylgruppe ist, so kann dies z.B. Fluorphenyl, Chlorphenyl, Bromphenyl, Dichlorphenyl, Tolyl, Xylyl, Chlortolyl, Isopropylphenyl, tert.-Butylphenyl, 1,1,3,3-Tetramethylbutylphenyl, n-Octylphenyl, Isononylphenyl, n-Decylphenyl, n-Dodecylphenyl, n-Octadecylphenyl, Allylphenyl, Methallylphenyl, Methoxyphenyl, Ethoxyphenyl, Isopropoxyphenyl, Butoxyphenyl, Octyloxyphenyl, Phenoxyphenyl, Methylthiophenyl, Ethylthiophenyl, Butylthiophenyl, Dodecylthiophenyl, Allylthiophenyl, 2-Hydroxyethylthiophenyl, Phenylthiophenyl, Tolylthiophenyl, Methylaminophenyl, Dimethylaminophenyl, Mono- oder Diethylaminophenyl, Mono- oder Dibutylaminophenyl, Mono- oder Dioctylaminophenyl, Mono- oder Didodecylaminophenyl, Bis(2-hydroxyethyl(aminophenyl, Bis(2-hydroxypropyl)aminophenyl, Diallylaminophenyl, Bis(2-methoxyethyl)aminophenyl, Morpholinophenyl, Piperazinophenyl oder Pyrrolidinophenyl sein. Bevorzugt steht ein Substituent in 4-Stellung der Phenylgruppe.

$R^1$ und $R^2$ können z.B. Methyl, Ethyl, Propyl, Butyl, Hexyl, Octyl, 2-Hydroxyethyl, 2-Methoxyethyl, Hydroxymethyl, Ethoxymethyl, 2-Butoxyethyl, Benzyloxymethyl, 2-Cyanoethyl, 2-Methoxycarbonylethyl, Ethoxycarbonylmethyl, 2-Hexyloxycarbonylethyl, 2-Acetyloxyethyl, Propionyloxymethyl, 2-Butyroyloxyethyl, 2-Dimethylaminoethyl, 2-Diethylaminopropyl, 2-Dibutylaminoethyl, Morpholinomethyl oder 2-Morpholinoethyl

sein. Wenn $R^1$ und $R^2$ zusammen Alkandiyl, Oxa- oder Azaalkandiyl oder Alkendiyl sind, so bilden sie zusammen mit dem C-Atom, an das sie gebunden sind, einen gesättigten oder einfach ungesättigten carbocyclischen oder heterocyclischen 5- oder 6-gliedrigen Ring, der durch Alkylgruppen substituiert sein kann.

Vorzugsweise bedeuten $R^1$ und $R^2$ Methyl oder beide zusammen Pentamethylen.

$R^3$ als Alkyl oder substituiertes Alkyl kann z.B. Methyl, Ethyl, Propyl, Isopropyl, Butyl, Hexyl, Octyl, 2-Chorethyl, 4-Brombutyl, 2-Hydroxypropyl, 2-Hydroxyethyl, 2-Methoxyethyl, 2-Butoxyethyl oder 3-Methoxypropyl sein.

$R^4$ und $R^5$ als Alkyl oder substituiertes Alkyl können z.B. Methyl, Ethyl, Propyl, Butyl, Isopropyl, Hexyl, 2-Ethylhexyl, Octyl, Dodecyl, 2-Hydroxyethyl, 2-Hydroxypropyl, 2-Methoxyethyl, 2-Isopropoxyethyl, 2-Ethoxypropyl, 2-Cyanoethyl, 2-Methoxycarbonyl-ethyl, 2-Ethoxycarbonyl-ethyl, 2-Methoxycarbonyl-propyl oder 2-Butoxycarbonyl-ethyl sein. Wenn $R^4$ und $R^5$ zusammen Alkylen bedeuten, so kann das Alkylen verzweigt oder unverzweigt sein und durch -O- oder $-NR^6-$ unterbrochen sein. In diesem Fall bilden $R^4$ und $R^5$ zusammen mit dem N-Atom, an das sie gebunden sind, einen heterocyclischen Ring, beispielsweise einen Pyrrolidin-, Piperidin-, Methylpiperidin-, Morpholin-, Dimethylmorpholin-, Piperazin-, 4-Methylpiperazin-, 4-Isopropylpiperazin, 4-Allylpiperazin-, 4-Benzylpiperazin-oder 4-(2-Hydroxyethyl)-piperazinring.

In den Verbindungen der Formel II und IV ist das Titan-Atom an zwei $\pi$-Anionen vom Cyclopentadienyltyp $R^7$ und $R^8$ gebunden.

Die beiden Anionen können untereinander über die Brücke Z kovalent verknüpft sein, wodurch ein Ligand der Formel III entsteht.

Beispiele für solche Gruppen Z sind

$-CH_2-$, $-CH_2CH_2-$, $CH_3CH<$,

$C_3H_7CH<$, 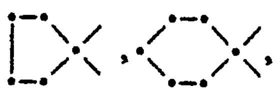, $(CH_3)_2Si<$, $(C_6H_5)(CH_3)Si<$, $(C_4H_9)_2Sn<$

oder $(C_8H_{17})_2Sn<$.

Bevorzugt ist Z eine Methylengruppe.

In den Verbindungen der Formel II ist das Titan ausserdem an mindestens einen aromatischen Rest $R^9$ kovalent gebunden. Der aromatische Rest kann carbocyclisch oder heterocyclisch sein und muss in Orthostellung zur C-Ti-Bindung durch Fluor substituiert sein. Beispiele für solche aromatische Reste sind fluorierte Benzole, Naphthaline, Furane, Thiophene, Pyrrole, Pyridine, Pyrimidine, Pyrazole, Imidazole, Oxazole oder Thiazole, die ausserdem noch andere Substituenten tragen können wie Halogenatome, Alkyl- oder Alkoxygruppen, Alkoxycarbonyl- oder Aminocarbonylgruppen, Aminogruppen oder Aminoalkylgruppen sowie deren Quaternierungsprodukte. Beispiele für solche Substituenten am aromatischen Rest sind Fluor, Chor, Brom, Methyl, Ethyl, iso-Propyl, tert.Butyl, n-Nonyl oder n-Dodecyl, Methoxy, Ethoxy, Butoxy, Hexyloxy, Octyloxy, Decyloxy oder Dodecyloxy, Methoxycarbony, Ethoxycarbonyl, Butoxycarbonyl, 2-Ethylhexyloxycarbonyl oder n-Decyloxycarbonyl, Aminocarbonyl, Butylaminocarbonyl, Diethylaminocarbonyl oder Pyrrolidinocarbonyl, $-NH_2$, $-NHC_4H_9$, $-N(CH_3)_2$, $-N(CH_3)_3^{\oplus}Cl^{\ominus}$, Morpholino, Piperidino, $-CH_2NH_2$, $-CH_2N(C_2H_5)_2$, $-CH_2N(C_2H_5)_3^{\oplus}Br^{\ominus}$ oder Pyrrolidinomethyl.

Bevorzugt ist $R^9$ ein Benzolrest, der in beiden Orthostellungen durch Fluor substituiert ist.

$R^{10}$ kann ebenfalls ein einwertiger fluor-aromatischer Rest sein oder ist eine Alkinyl- oder Phenylalkinylgruppe, die im Phenylrest entsprechend substituiert sein kann, oder $R^{10}$ ist ein unsubstituierter oder mit Halogen substituierter Acyloxy-, Azido-, Cyano-, Triorganosilyl- oder Triorganostannyl-Rest.

Wenn $R^{10}$ Alkinyl ist, so kann es z.B. Ethinyl, 1-Propinyl, 1-Butinyl, 2-Hexinyl, 1-Octinyl, 1-Decinyl oder 1-Dodecinyl sein. $R^{10}$ als unsubstituiertes oder substituiertes Phenylakinyl kann z.B. 2-Phenylethinyl, 3-Phenylpropinyl, 3-Phenylbutinyl, 2-(4-Chlorphenyl)ethinyl oder 3-(4-Tolyl)-propinyl sein.

$R^{10}$ als Triorganosilyl- oder Triorganostannylrest kann z.B. Trimethylsilyl, Triphenylsilyl, Dimethylphenyl-silyl, Methyl-diphenylsilyl, Trimethylsilyl, Tributylsilyl, Trimethylstannyl, Tributylstannyl, Trioctylstannyl oder Tri(dodecyl)stannyl sein.

$R^9$ und $R^{10}$ können verknüpft sein zu einem zweiwertigen aromatischen Rest der Formel -Q-Y-Q-. Darin sind Q carbocyclische oder heterocyclische Reste, die in 2-Stellung zur Verknüpfung Y an das Titanatom gebunden sind und in 3-Stellung durch Fluor substituiert sind. Beispiele für solche zweiwertige Gruppen sind die folgenden Gruppen, worin E -O-, -S- oder -NH- bedeutet:

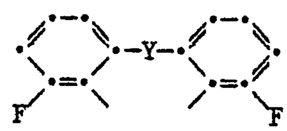
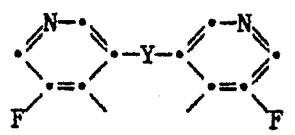

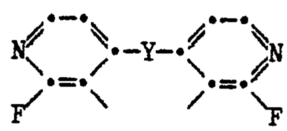
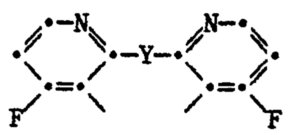

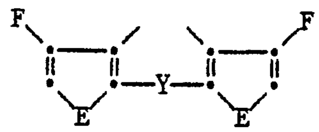
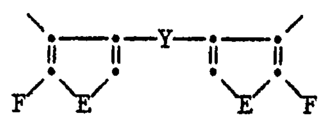

Die aromatischen Reste Q können weitere Substituenten tragen, insbesondere Halogen, Methyl und Dimethylamino. Das Brückenglied Y kann eine direkte Bindung, ein zweiwertiges Atom oder eine zweiwertige Gruppe sein. Bevorzugt ist

$$Y\ -CH_2-,\ CH_3CH\langle,\ C_2H_5CH\langle,$$

-S-, -O- oder eine direkte Bindung.

Bevorzugt sind $R^9$ und $R^{10}$ gleich und sind ein substituierter Phenylrest, insbesondere ein 2,6-Difluorphenylrest, der noch weitere Substituenten tragen kann.

Beispiele für Verbindungen der Formel II sind:

Bis(cyclopentadienyl)-bis(pentafluorphenyl)-titan
Bis(cyclopentadienyl)-bis(3-brom-tetrafluorphenyl)-titan
Bis(cyclopentadienyl)-bis(4-brom-tetrafluorphenyl)-titan
Bis(cyclopentadienyl)-bis(2,4,5,6-tetrafluorphenyl)-titan
Bis(cyclopentadienyl)-bis(3,5-dichlor-2,4,6-trifluorphenyl-titan
Bis(cyclopentadienyl)-bis(4-morpholino-tetrafluorphenyl)-titan
Bis(cyclopentadienyl)-bis(4-[4′methylpiperazino]-tetrafluorphenyl)-titan
Bis(cyclopentadienyl)-bis(4-dibutylamino-tetrafluorphenyl)-titan
Bis(cyclopentadienyl)-bis(2,4,6-trifluorphenyl)-titan
Bis(methylcyclopentadienyl)-bis(pentafluorphenyl)-titan
Bis(methylcyclopentadienyl)-bis(4-morpholino-tetrafluorphenyl)-titan
Bis(methylcyclopentadienyl)-bis(4-[4′-methylpiperazino]-tetrafluorphenyl)-titan
Bis(cyclopentadienyl)-bis(4-[dimethylaminomethyl]-tetrafluorphenyl)-titan
Bis(cyclopentadienyl)-bis(2,3,5,6-tetrafluorphenyl)-titan
Bis(methylcyclopentadienyl)-bis(2,3,5,6-tetrafluorphenyl)-titan
Bis(methylcyclopentadienyl)-bis(2,4,6-trifluorphenyl)-titan
Bis(cyclopentadienyl)bis(2,3,6-trifluorphenyl)-titan
Bis(methylcyclopentadienyl)-bis(2,6-difluorphenyl)-titan
Bis(cyclopentadienyl)-bis(2,6-difluor-3-methoxy-phenyl)-titan
Bis(cyclopentadienyl)-bis(2,6-difluor-3-propoxy-phenyl)-titan
Bis(cyclopentadienyl)-bis(2,6-difluor-3-hexyloxy-phenyl)-titan
Bis(cyclopentadienyl)-bis[2,6-difluor-3-(2-ethoxy-ethoxy)phenyl]-titan
Bis(cyclopentadienyl)-bis(2,6-difluor-3-methylphenyl)-titan
Bis(cyclopentadienyl)-bis(4-methoxy-tetrafluorphenyl)-titan
Bis(cyclopentadienyl)-bis(4-butoxy-tetrafluorphenyl)-titan
Bis(cyclopentadienyl)-bis(4-isopropoxy-tetrafluorphenyl)-titan
Bis(cyclopentadienyl)-bis(4-[2-ethylhexyloxy]-tetrafluorphenyl)-titan
Bis(cyclopentadienyl)-bis(4-decyloxy-tetrafluorphenyl)-titan
Bis(cyclopentadienyl)-bis(4-dodecyloxy-tetrafluorphenyl)-titan
Bis(cyclopentadienyl)-bis(4-octyloxy-tetrafluorphenyl)-titan
Bis(methylcyclopentadienyl)-bis(4-octyloxy-tetrafluorphenyl)-titan
Bis(methylcyclopentadienyl)-bis(4-decyloxy-tetrafluorphenyl)-titan

Bis(methylcyclopentadienyl)-bis(4-dodecyloxy-tetrafluorphenyl)-titan
Bis(methylcyclopentadienyl)-bis(4-butoxy-tetrafluorphenyl)-titan
Bis(methylcyclopentadienyl)-bis(4-ethoxy-tetrafluorphenyl)-titan
Bis(methylcyclopentadienyl)-bis(4-isopropoxy-tetrafluorphenyl)-titan
Bis(methylcyclopentadienyl)-bis(4-dibutylamino-tetrafluorphenyl)-titan
Bis(cyclopentadienyl)-bis(2,6-difluorphenyl)-titan
Bis(cyclopentadienyl)-bis(2,4,5-trifluorphenyl)-titan
Bis(cyclopentadienyl)-bis(2,3-difluorphenyl)-titan
Bis(cyclopentadienyl)-bis(2,5-difluorphenyl)-titan
Bis(cyclopentadienyl)-bis(2,3,4,5-tetrafluorphenyl)-titan
Bis(methylcyclopentadienyl)-bis(2,3,4,5-tetrafluorphenyl)-titan
Bis(methylcyclopentadienyl)-bis(2,3,4,6-tetrafluorphenyl)-titan
Bis(methylcyclopentadienyl)-bis(2,3,6-trifluorphenyl)-titan
Bis(dimethylcyclopentadienyl)-bis(pentafluorphenyl)-titan
Bis(cyclopentadienyl)-3,4,5,6,3',4',5',6'-octafluordiphenylsulfid-2,2'-diyl-titan
Bis(cyclopentadienyl)-bis(4-[4,4-dimethylpiperazino]-tetrafluorphenyl)-titan-diiodid
Bis(cyclopentadienyl)-bis(4-[trimethylammonium-methyl]-tetrafluorphenyl)-titan-diiodid

In den Verbindungen der Formel IV ist das Titan ebenso wie in den Verbindungen der Formel II an zwei $\pi$-Anionen vom Cyclopentadienyltyp $R^7$ und $R^8$ gebunden. Die anderen beiden Liganden $R^{14}$ und $R^{15}$ unterscheiden sich jedoch von $R^9$ und $R^{10}$ dadurch, dass der aromatische Rest $R^{14}$ mindestens in einer ortho-Postion eine $CF_3$-Gruppe enthält. Der Rest $R^{15}$ kann ebenfalls ein ortho-Trifluormethyl-Aromat sein oder ist Alkinyl, Phenylalkinyl, Halogen, $-Si(R^{11})_3$, $-Si(R^{11})_2(R^{12})$, $-Sn(R^{11})_3$, -OH, Alkoxy, Aryloxy, Acyloxy, -CN, $-N_3$, -NCO oder -NCS, analog zum Rest $R^{10}$. $R^{15}$ als Halogen ist insbesondere Fluor, Chlor oder Brom.

Beispiele für Verbindungen der Formel IV sind:

Bis(cyclopentadienyl)-2-(trifluormethyl)phenyl-titan-chlorid oder -bromid oder -fluorid oder -acetat oder -trifluoracetat
Bis(cyclopentadienyl)-bis-(2-trifluormethyl)phenyl-titan
Bis(methylcyclopentadienyl)-2-(trifluormethyl)phenyl-titan-chlorid oder -fluorid oder -acetat oder -trifluoracetat
Bis(cyclopentadienyl)-(2-trifluormethyl-6-fluorphenyl)-titan-fluorid
Bis(cyclopentadienyl)-2,5-bis(trifluormethyl)phenyl-titan-chlorid
Bis(indenyl)-2,5-bis(trifluormethyl)phenyl-titan-chlorid
Bis(methylcyclopentadienyl)-2-(trifluormethyl)phenyl-titan-rhodanid oder -isocyanat oder -cyanid
Bis(cyclopentadienyl)-2-(trifluormethyl)phenyl-titan-rhodanid oder -azid
Bis(cyclopentadienyl)-(2-trifluormethyl-4-methoxyphenyl)-titan-chlorid
Bis(cyclopentadienyl)bis(2-trifluormethyl-4-tolyl)-titan.

In den erfindungsgemässen Gemischen beträgt das prozentuale Gewichtsverhältnis von A : B = 70 - 99,9 : 0,1 - 30, bevorzugt ist ein Verhältnis von 80-99,5 Gew.-% A : 0,5-20 Gew.-% B. Die Komponente A stellt also mengenmässig den Hauptanteil dar.

Bevorzugt sind Gemische bestehend aus

A) 80-99,5 Gew.-% eines flüssigen Photoinitiators oder Photoinitiatorgemisches enthaltend mindestens eine Verbindung der Formel I, worin
Ar eine unsubstituierte oder durch einen oder zwei der Substituenten Halogen, $C_1$-$C_{12}$-Alkyl, $C_1$-$C_8$-Alkoxy, Allyloxy, Phenoxy, $C_1$-$C_8$-Alkylthio, 2-Hydroxyethylthio, Allylthio, Phenylthio, $C_1$-$C_8$-Alkylamino, $C_2$-$C_{16}$-Dialkylamino, Diallylamino, $C_4$-$C_6$-Bis(hydroxyalkyl)amino, Bis(2-methoxyethyl)amino, Morpholino, Piperidino oder Pyrrolidino substituierte Phenylgruppe bedeutet,
$R^1$ und $R^2$ unabhängig voneinander $C_1$-$C_6$-Alkyl oder durch -OH, $C_1$-$C_4$-Alkoxy, Benzyloxy, -COO($C_1$-$C_4$-Alkyl), $C_2$-$C_4$-Dialkylamino oder Morpholino substituiertes $C_1$-$C_4$-Alkyl bedeuten oder
$R^1$ und $R^2$ zusammen $C_3$-$C_6$-Alkandiyl oder $C_5$-$C_7$-Alkendiyl bedeuten,
X eine Gruppe $-OR^3$ oder $-NR^4R^5$ bedeutet, worin
$R^3$ Wasserstoff, $C_1$-$C_4$-Alkyl, durch -OH oder $C_1$-$C_4$-Alkoxy substituiertes $C_2$-$C_4$-Alkyl, Allyl, Benzyl, 2-Tetrahydropyranyl oder Trimethylsilyl bedeutet und $R^4$ und $R^5$ unabhängig voneinander Wasserstoff, $C_1$-$C_8$-Alkyl, durch -OH oder $C_1$-$C_4$-Alkoxy substituiertes $C_2$-$C_4$-Alkyl, Allyl, Benzyl oder Cyclohexyl bedeuten oder $R^4$ und $R^5$ zusammen $C_3$-$C_7$-Alkylen bedeuten, das durch -O- oder $-N(R^6)$-unterbrochen sein kann, wobei $R^6$ Wasserstoff, Methyl oder $C_2$-$C_4$-Hydroxyalkyl bedeutet, und

B) 0,5-20 Gew.-% einer Verbindung der Formel II, worin $R^7$ und $R^8$ ein unsubstituiertes oder durch $C_1$-$C_4$-Alkyl substituiertes Cyclopentadienyl-Anion sind und
$R^9$ und $R^{10}$ eine Gruppe der Formel V bedeuten,

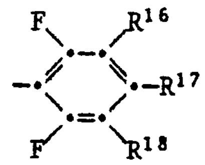 (V)

worin $R^{16}$, $R^{17}$ und $R^{18}$ unabhängig voneinander Wasserstoff, F, Cl, Br, $C_1$-$C_{14}$-Alkoxy, $-O-(CH_2CH_2O)_{1-8}$ $C_1$-$C_{14}$-Alkyl eine tertiäre Aminogruppe oder Aminomethylgruppe mit 2 - 20 C-Atomen oder eine quartäre Ammonium- oder Ammonium-methylgruppe mit 3 - 24 C-Atomen bedeuten oder

$R^9$ und $R^{10}$ zusammen eine zweiwertige Gruppe der Formel

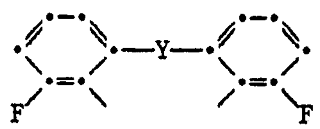

darstellen, worin Y die oben angegebene Bedeutung hat,

oder 0,5-20 Gew.-% einer Verbindung der Formel IV worin $R^7$ und $R^8$ ein unsubstituiertes oder durch $C_1$-$C_4$-Alkyl substituiertes Cyclopentadienyl-Anion sind und $R^{14}$ eine Gruppe der Formel VI bedeutet,

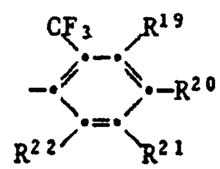 (VI)

worin $R^{19}$, $R^{20}$, $R^{21}$ und $R^{22}$ unabhängig voneinander Wasserstoff, F, Cl, Br oder $C_1$-$C_{14}$-Alkoxy bedeuten und $R^{15}$ eine der für $R^{14}$ gegebenen Bedeutungen hat oder F, Cl, Br, CN, $-O-CO-CH_3$, $-O-CO-CF_3$, $N_3$, -NCO oder -NCS bedeutet.

Ist die Verbindung der Formel I eine flüssige Verbindung, so kann die Komponente A nur aus einer solchen Verbindung bestehen. Ist die Verbindung der Formel I eine feste Verbindung, so kann entweder deren flüssiges Gemisch mit einer anderen Verbindung der Formel I oder mit einem oder mehreren anderen metallfreien Photoinitiatoren als Komponente A verwendet werden. Vorzugsweise ist diese Zweitkomponente eine flüssige Verbindung oder ein flüssiges Gemisch. Die Zweitkomponente kann aber auch fest sein, wenn sie mit der ersten Komponente ein flüssiges Eutektikum bildet. Ein Beispiel für ein solches Eutektikum zweier fester Photoinitiatoren ist eine 1:1-Mischung von 1-Hydroxycyclohexyl-phenyl-keton und Benzophenon.

Beispiele für flüssige Verbindungen der Formel I sind:

2-Hydroxy-2-methyl-1-phenyl-propanon-1
2-Ethyl-2-hydroxy-1-phenyl-hexanon-1
2-Hydroxy-2-methyl-1-(4-tolyl)-propanon-1
1-(4-Ethylphenyl)-2-hydroxy-2-methyl-propanon-1
1-(4-Cumyl)-2-hydroxy-2-methyl-propanon-1
1-(4-tert.-Butylphenyl)-2-hydroxy-2-methyl-propanon-1
1-(4-Dodecylphenyl)-2-hydroxy-2-methyl-propanon-1
2-Ethyl-2-hydroxy-1-(4-tolyl)-hexanon-1
1-(4-tert.-Butylphenyl)-2-ethyl-2-hydroxy-hexanon-1
1-(3,4-Dimethylphenyl)-2-hydroxy-2-methyl-propanon-1
1-(2,4-Dimethylphenyl)-2-hydroxy-2-methyl-propanon-1
1-(2,5-Dimethylphenyl)-2-hydroxy-2-methyl-propanon-1
1-(3-Chlor-4-methylphenyl)-2-hydroxy-2-methyl-propanon-1
1-(4-Chlorphenyl)-2-hydroxy-2-methyl-propanon-1
1-(4-Fluorphenyl)-2-hydroxy-2-methyl-propanon-1
2-Ethyl-1-(4-fluorphenyl)-2-hydroxy-hexanon-1
1-(4-Dimethylaminophenyl)-2-ethyl-2-hydroxy-hexanon-1
2-Hydroxy-1-(4-methoxyphenyl)-2-methyl-propanon-1

2-Ethyl-2-hydroxy-1-(4-methoxyphenyl)-hexanon-1
2-Hydroxy-2-methyl-1-(4-phenoxyphenyl)-propanon-1
2-Hydroxy-2-methyl-1-(4-phenylthiophenyl)-propanon-1
2-Hydroxy-2-methyl-1-phenyl-butanon-1
2-Ethyl-2-hydroxy-phenyl-butanon-1
(2,4-Dimethylphenyl)-(1-hydroxycyclohexyl)-keton
(1-Hydroxycyclopentyl)-phenyl-keton
(1-Hydroxycyclobutyl)-phenyl-keton
(1-Hydroxy-3,4-dimethyl-3-cyclohexen-1-yl)-phenyl-keton
(1-Hydroxy-4-methyl-3-cyclohexen-1-yl)-phenyl-keton
(1-Hydroxy-3-cyclohexen-1-yl)-phenyl-keton
(1-Hydroxy-2-cyclohexen-1-yl)-phenyl-keton
[1-(Trimethylsilyloxy)cyclohexyl]-phenyl-keton
[1-(Trimethylsilyloxy)cyclopentyl]-phenyl-keton
[1-(Trimethylsilyloxy)cyclobutyl]-phenyl-keton
2-Methyl-1-phenyl-2-(trimethylsilyloxy)-propanon-1
2-Methyl-1-phenyl-2-(phenyl-dimethyl-silyloxy)-propanon-1
1-(4-Chlorphenyl)-2-methyl-2-(trimethylsilyloxy)-propanon-1
2-Methyl-2-(trimethylsilyloxy)-1-(4-tolyl)-propanon-1
2-Methoxy-2-methyl-1-phenyl-propanon-1
2-Butoxy-2-methyl-1-phenyl-propanon-1
2-(4-Brombutyloxy)-2-methyl-1-phenyl-propanon-1
2-Allyloxy-2-methyl-1-phenyl-propanon-1
2-Benzyloxy-2-methyl-1-phenyl-propanon-1
2-(2-Methoxyethyloxy)-2-methyl-1-phenyl-propanon-1
2-(1-Ethoxyethyloxy)-2-methyl-1-phenyl-propanon-1
2-Methyl-1-phenyl-2-(tetrahydro-2H-pyran-2-yloxy)-propanon-1
(1-Methoxycyclohexyl)-phenyl-keton
(1-Methoxycyclohexyl)-(4-methoxyphenyl)-keton
2-Hydroxy-3-methoxy-2-methyl-1-phenyl-propanon-1
3-Benzyloxy-2-hydroxy-2-methyl-1-phenyl-propanon-1
3-Diethylamino-2-hydroxy-2-methyl-1-phenyl-propanon-1
2-Hydroxy-2-methyl-3-morpholino-1-phenyl-propanon-1
(3-Methoxy-1-methyl-3-piperidyl)-phenyl-keton
4-Hydroxy-4-methyl-5-phenyl-5-oxo-pentansäuremethylester
2-Dimethylamino-2-methyl-1-phenyl-propanon-1
2-Diethylamino-2-methyl-1-phenyl-propanon-1
2-Dipropylamino-2-methyl-1-phenyl-propanon-1
2-Dibutylamino-2-methyl-1-phenyl-propanon-1
2-Ethylmethylamino-2-methyl-1-phenyl-propanon-1
2-Methyl-1-phenyl-2-propylmethylamino-propanon-1
2-Methyl-2-methylamino-1-phenyl-propanon-1
2-Ethylamino-2-methyl-1-phenyl-propanon-1
2-Butylamino-2-methyl-1-phenyl-propanon-1
2-(2-Methylpiperidino)-2-methyl-1-phenyl-propanon-1
2-Methyl-2-pyrrolidino-1-phenyl-propanon-1
2-Methyl-2-piperazino-1-phenyl-propanon-1
2-Diallylamino-2-methyl-1-phenyl-propanon-1
2-Bis-(2-methoxyethyl)amino-2-methyl-1-phenyl-propanon-1
2-Methyl-2-methylamino-1-phenyl-butanon-1
2-Ethyl-2-methylamino-1-phenyl-butanon-1
4-Dimethylamino-4-methyl-5-phenyl-5-oxo-pentansäuremethylester
(1-Dimethylaminocyclohexyl)-phenyl-keton
(1-Methylaminocyclohexyl)-phenyl-keton
(1-Methylaminocyclopentyl)-phenyl-keton
(1-Ethylaminocyclopentyl)-phenyl-keton
1-(4-Chlorphenyl)-2-dimethylamino-2-methyl-propanon-1
1-(4-Chlorphenyl)-2-dibutylamino-2-methyl-propanon-1

1-(4-Chlorphenyl)-2-ethylamino-2-methyl-propanon-1
1-(4-Chlorphenyl)-2-bis-(2-methoxyethyl)amino-2-methyl-propanon-1
1-(4-Chlorphenyl)-2-methyl-2-(4-methylpiperazino)-propanon-1
1-(4-Chlorphenyl)-2-methyl-2-piperidino-propanon-1
2-Diethylamino-1-(4-fluorphenyl)-2-methyl-propanon-1
2-Diallylamino-1-(4-fluorphenyl)-2-methyl-propanon-1
2-Dimethylamino-1-(4-fluorphenyl)-2-methyl-propanon-1
2-Bis-(2-methoxyethyl)amino-1-(4-fluorphenyl)-2-methyl-propanon-1
1-(4-Fluorphenyl)-2-methyl-2-methylamino-propanon-1
1-(4-Fluorphenyl)-2-methyl-2-(4-methylpiperazino)-propanon-1
1-(4-Fluorphenyl)-2-methyl-2-morpholino-butanon-1
1-(4-Fluorphenyl)-2-methyl-2-morpholino-pentanon-1
1-(4-Fluorphenyl)-2-ethyl-2-morpholino-hexanon-1
(1-Ethylaminocyclopentyl)-(4-tolyl)-keton
(1-Ethylaminocyclopentyl)-(2-tolyl)-keton
2-Methyl-2-piperidino-1-(4-tolyl)-propanon-1
2-Dimethylamino-2-methyl-1-(4-methylthiophenyl)-propanon-1
2-Dimethylamino-2-methyl-1-(4-phenylthiophenyl)-propanon-1
2-Dimethylamino-2-methyl-1-[4-(4-tolylthio)phenyl]-propanon-1
2-Diethylamino-2-methyl-1-(4-methylthiophenyl)-propanon-1
2-Dibutylamino-2-methyl-(4-methylthiophenyl)-propanon-1
2-Dibutylamino-2-methyl-(4-phenylthiophenyl)-propanon-1
2-Bis-(2-methoxyethyl)amino-2-methyl-1-(4-methylthiophenyl)-propanon-1
2-Bis-(2-methoxyethyl)amino-2-methyl-1-(4-phenylthiophenyl)-propanon-1
2-Butylamino-2-methyl-1-(4-methylthiophenyl)-propanon-1
2-Methyl-1-(4-methylthiophenyl)-2-pyrrolidino-propanon-1
2-Methyl-1-(4-methylthiophenyl)-2-morpholino-butanon-1
2-Methyl-1-(4-methylthiophenyl)-2-morpholino-pentanon-1
2-Ethyl-2-(4-methylthiophenyl)-2-morpholino-hexanon-1
2-Ethyl-1-(4-methylthiophenyl)-2-piperidino-hexanon-1
2-Ethyl-1-(4-methylthiophenyl)-2-(4-methylpiperazino)-hexanon-1
2-(2,6-Dimethylmorpholin-4-yl)-2-methyl-1-(4-methylthiophenyl)-propanon-1
2-Dimethylamino-1-(4-methoxyphenyl)-2-methyl-propanon-1
2-Dibutylamino-1-(4-methoxyphenyl)-2-methyl-propanon-1
2-Diallylamino-1-(4-methoxyphenyl)-2-methyl-propanon-1
2-Bis-(2-methoxyethyl)amino-1-(4-methoxyphenyl)-2-methyl-propanon-1
2-(2-Methoxyethyl)amino-1-(4-methoxyphenyl)-2-methyl-propanon-1
1-(4-Methoxyphenyl)-2-methyl-2-(1-methyl-2-methoxy-ethyl)amino-propanon-1
1-(4-Methoxyphenyl)-2-methyl-2-piperazino-propanon-1
2-(2,4-Dimethylmorpholin-4-yl)-1-(4-methoxyphenyl)-2-methyl-propanon-1
1-(4-Methoxyphenyl)-2-methyl-2-morpholino-butanon-1
2-Ethyl-1-(4-methoxyphenyl)-2-morpholino-hexanon-1
(4-Methoxyphenyl)-(1-morpholinocyclohexyl)-keton
(4-Methoxyphenyl)-(1-methylaminocyclopentyl)-keton
1-(4-Allyloxyphenyl)-2-methyl-2-morpholino-propanon-1
2-Methyl-1-(4-phenoxyphenyl)-2-piperidino-propanon-1
1-(4-Methoxyphenyl)-2-methyl-2-piperidino-propanon-1
2-Diethylamino-1-(4-diethylaminophenyl)-2-methyl-propanon-1
2-Diallylamino-1-(4-diallylaminophenyl)-2-methyl-propanon-1
2-Methylamino-2-methyl-1-(4-morpholinophenyl)-propanon-1
2-Dimethylamino-1-(4-dimethylaminophenyl)-2-methyl-pentanon-1
2-Methyl-2-morpholino-1-(4-morpholinophenyl)-pentanon-1
2-Ethyl-2-morpholino-1-(4-morpholinophenyl)-hexanon-1
2-Bis-(2-methoxyethyl)amino-1-(4-dimethylaminophenyl)-2-methyl-propanon-1
2-Bis-(2-methoxyethyl)amino-1-(4-morpholinophenyl)-2-methyl-propanon-1
1-[4(Bis-(2-methoxyethyl)amino)phenyl]-2-methyl-2-morpholino-propanon-1.

Solche flüssigen Verbindungen der Formel I können allein oder im Gemisch mit einer anderen Verbindung der Formel I oder im Gemisch mit einem andern Photoinitiator als Komponente A verwendet

werden. Die Verwendung eines Gemisches kann den Vorteil haben, dass dadurch der Erstarrungspunkt der Komponente A erniedrigt wird oder dass die Wirksamkeit erhöht wird.

Die Verwendung eines Gemisches als Komponente A ist vor allem dann von Bedeutung, wenn man eine feste Verbindung der Formel I verwenden möchte. Beispiele hierfür sind flüssige Gemische einer Verbindung der Formel I und einer Verbindung der Formel VII,

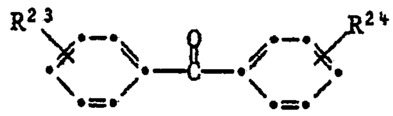
(VII)

worin $R^{23}$ und $R^{24}$ unabhängig voneinander Wasserstoff, $C_1$-$C_{12}$-Alkyl, $C_1$-$C_4$-Alkoxy, $C_1$-$C_4$-Alkylthio, $C_2$-$C_4$-Hydroxyalkyloxy, $C_2$-$C_4$-Hydroxyalkylthio, Halogen, $C_2$-$C_{10}$-Alkoxycarbonyl oder $C_2$-$C_8$-Dialkylamino bedeuten. Die Verbindungen der Formel VII sind für sich allein als Photoinitiatoren bekannt.

Beispiele solcher Verbindungen der Formel VII sind: Benzophenon, 2-Methylbenzophenon, 4-Methylbenzophenon, 4-Isopropylbenzophenon, 4-Chlorbenzophenon, 2,2'-Dichlorbenzophenon, 4-Methoxybenzophenon, 4-Ethoxybenzophenon, 4-(2-Hydroxyethylthio)-benzophenon, 4-(2-Hydroxypropyloxy)-benzophenon, 4-Dimethylaminobenzophenon, 4,4'-Bis-(dimethylamino)benzophenon, 4-Ethoxycarbonylbenzophenon oder 4-tert.Butoxycarbonylbenzophenon. Bevorzugt sind flüssige Gemische aus einer Verbindung der Formel I und Benzophenon.

Das Gewichtsverhältnis von Verbindung der Formel I und Verbindung von Formel VII beträgt vorzugsweise 0,8:1 bis 1:0,8.

Weitere Beispiele sind flüssige Gemische aus einer Verbindung der Formel I und einem 2,4,6-Tri($C_1$-$C_4$-alkyl)benzophenon, beispielsweise 2,4,6-Trimethylbenzophenon, oder Gemische aus einer Verbindung der Formel I, einem 2,4,6-Tri($C_1$-$C_{14}$-alkyl)benzophenon und Benzophenon.

Andere Beispiele für Gemische sind solche aus einer Verbindung der Formel I und einer Verbindung der Formel VIII

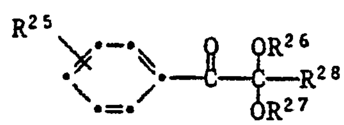
(VIII)

worin $R^{25}$ Halogen, $C_1$-$C_4$-Alkyl oder $C_1$-$C_{14}$-Alkoxy bedeutet, $R^{26}$ und $R^{27}$ $C_1$-$C_6$-Alkyl, $C_3$-$C_4$-Alkenyl, $C_7$-$C_{10}$-Phenylalkyl oder durch Halogen, $C_1$-$C_4$-Alkoxy, $C_2$-$C_8$-Dialkylamino, Morpholino oder Piperidino substituiertes $C_2$-$C_4$ Alkyl bedeuten oder $R^{26}$ und $R^{27}$ zusammen $C_2$-$C_{12}$-Alkandiyl oder 2-Buten-1,4-diyl bedeuten und $R^{28}$ Wasserstoff, $C_1$-$C_8$-Alkyl, $C_5$-$C_8$-Cycloalkyl, Phenyl oder durch Halogen, $C_1$-$C_4$-Alkyl oder $C_1$-$C_4$-Alkoxy substituiertes Phenyl bedeutet.

Die Verbindungen der Formel VIII sind als Photoinitiatoren bekannt. Beispiele hierfür sind 2,2-Dimethoxyacetophenon, 2,2-Diethoxyacetophenon, 2,2-Dibutoxyacetophenon, 2,2-Dimethoxypropiophenon, 2,2-Diethoxy-p-chloracetophenon, 2,2-Dimethoxy-2-phenylacetophenon, 2,2-Diethoxy-2-phenylacetophenon, 2,2-Dimethoxy-2-(4-methylphenyl)-p-methylacetophenon, 2-Benzoyl-2-phenyl-4,7-dihydro-1,3-dioxepin oder 2-Benzoyl-2-phenyl-1,3-dioxolan.

Bevorzugt sind flüssige Gemische aus einer Verbindung der Formel I und 2,2-Dimethoxy-2-phenylacetophenon oder 2,2-Diethoxy-2-phenylacetophenon.

Das Gewichtsverhältnis von Verbindung der Formel I und Verbindung der Formel VIII beträgt vorzugsweise 2:1 bis 1:2.

Die Komponente A kann auch aus einem flüssigen Gemisch von zwei Verbindungen der Formel I bestehen. Beispiele hierfür sind 1-Hydroxycyclohexyl-phenyl-keton und 2-Hydroxy-2-methyl-1-phenylpropanon-1 im Verhältnis 1:1 oder 2-Methyl-1-(4-methylthiophenyl)-2-morpholino-propanon-1 und 2-Hydroxy-2-methyl-1-phenyl-propanon-1 im Verhältnis 2:8 oder flüssige Isomerengemische, entstanden bei der Herstellung von Verbindungen der Formel I.

Die Komponente A kann auch aus einem flüssigen Gemisch einer Verbindung der Formel I mit zwei anderen Photoinitiatoren bestehen, beispielsweise einem Gemisch aus einer Verbindung der Formel I, einer Verbindung der Formel VII und einer Verbindung der Formel VIII.

Unter den Verbindungen der Formel I sind solche bevorzugt, worin Ar Phenyl oder durch Chlor, Fluor, $C_1$-$C_{12}$-Alkyl, Methoxy, Methylthio, Dimethylamino, Diethylamino, Bis(2-methoxyethyl)amino, Morpholino,

Piperidino oder Pyrrolidino substituiertes Phenyl bedeutet, $R^1$ und $R^2$ unabhängig voneinander $C_1$-$C_4$-Alkyl oder durch -OH oder $C_1$-$C_4$-Alkoxy substituiertes $C_1$-$C_4$-Alkyl bedeuten oder $R^1$ und $R^2$ zusammen $C_4$-$C_6$-Alkandiyl oder $C_5$-$C_7$-Alkendiyl bedeuten und X -OH oder $-NR^4R^5$ ist, wobei $R^4$ und $R^5$ $C_1$-$C_4$-Alkyl, Allyl oder 2-Methoxyethyl bedeuten oder $R^4$ und $R^5$ zusammen mit dem Stickstoffatom Pyrrolidino, Piperidino, Morpholino, Piperazino oder 4-Methylpiperazino bedeuten.

Besonders bevorzugt sind Verbindungen der Formel I, worin Ar Phenyl, p-Tolyl, p-Cumyl, 4-Dodecylphenyl, 4-Chlorphenyl oder 4-Methoxyphenyl bedeutet, $R^1$ und $R^2$ unabhängig voneinander $C_1$-$C_4$-Alkyl oder $R^1$ und $R^2$ zusammen Tetra- oder Pentamethylen bedeuten und X eine Hydroxylgruppe ist, sowie Verbindungen der Formel I, worin Ar Phenyl, p-Tolyl, p-Cumyl, 4-Chlorphenyl, 4-Methoxyphenyl, 4-Methylthiophenyl, 4-Dimethylaminophenyl, 4-Diethylaminophenyl, 4-Bis-(2-methoxyethyl)amino-phenyl, 4-Morpholinophenyl oder 4-Piperidinophenyl bedeutet, $R^1$ und $R^2$ unabhängig voneinander $C_1$-$C_4$-Alkyl bedeuten und X Methylamino, Dimethylamino, Ethylamino, Diethylamino, Bis(2-methoxyethyl)amino, Piperidino, Pyrrolidino, Morpholino, Piperazino oder 4-Methylpiperazino bedeutet.

Als Komponente B verwendet man bevorzugt entweder eine Verbindung der Formel II, worin $R^7$ und $R^8$ ein Cyclopentadienyl- oder Methylcyclopentadienyl-Anion sind und $R^9$ und $R^{10}$ eine Gruppe der Formel V sind, worin entweder a) $R^{16}$ H, F, Cl oder Br ist, $R^{17}$ Fluor, $C_1$-$C_{14}$-Alkoxy oder $-O(CH_2CH_2O)_{\overline{1-6}}$ $C_1$-$C_{14}$-Alkyl ist und $R^{18}$ H, Cl oder Br ist oder b) $R^{18}$ H, F, Cl oder Br ist und $R^{16}$ und $R^{17}$ H, Cl, Br, $C_1$-$C_{14}$-Alkoxy, $-O(CH_2CH_2O)_{\overline{1-6}}$ $C_1$-$C_{14}$-Alkyl, eine tertiäre Amino- oder Aminomethylgruppe oder eine quartäre Ammonium-oder Ammonium-methylgruppe sind, oder eine Verbindung der Formel IV, worin $R^7$ und $R^8$ ein Cyclopentadienyl- oder Methylcyclopentadienyl-Anion sind, $R^{14}$ 2-(Trifluormethyl)phenyl oder 6-Fluor-2-(trifluormethyl)phenyl bedeutet und $R^{15}$ die gleiche Bedeutung wie $R^{14}$ hat oder F, Cl, Br, CN, $N_3$, -O-CO-$CH_3$, -O-CO-$CF_3$, -NCO oder -NCS ist.

Beispiele für besonders bevorzugte erfindungsgemässe Initiatorgemische sind solche aus 40-50 Gew.-% 1-Hydroxycyclohexyl-phenyl-keton, 40-50 Gew.-% Benzophenon und 5-20 Gew.-% einer Verbindung der Formel II oder IV, sowie solche aus 25-30 Gew.-% 1-Hydroxycyclohexyl-phenyl-keton, 25-30 Gew.-% Benzophenon, 35-40 Gew.-% 2,2-Dimethoxy-2-phenylacetophenon und 2-15 Gew.-% einer Verbindung der Formel II oder IV.

Zur Herstellung der erfindungsgemässen Initiatorgemische verrührt man die Komponente B in der Komponente A, bis eine klare Lösung entstanden ist. Vorzugsweise geschieht das Auflösen unter schwachem Erwärmen auf etwa 40 - 60 °C. Das Auflösen soll in Dunkelräumen mit Rotlicht-Beleuchtung geschehen, da die gelösten Titanocene gegen kurzwelliges Sonnenlicht (bis zu 600 nm) empfindlich sind. Die so erhaltenen Lösungen sind im Dunkeln lange Zeit haltbar.

Die erfindungsgemässen Initiatorgemische vermögen bei Bestrahlung mit kurzwelligem Licht die radikalische Polymerisation ethylenisch ungesättigter Verbindungen zu initieren. Mit ihrer Hilfe lassen sich daher photopolymerisierbare Verbindungen härten. Bei den photopolymerisierbaren Verbindungen handelt es sich um einfach oder mehrfach ethylenisch ungesättigte Verbindungen.

Beispiele von einfach ungesättigten Verbindungen sind Acrylate oder Methacrylate von einwertigen Alkoholen, Acrylamide und ähnliche Acrylsäurederivate, wie z.B. Methyl-, Ethyl-, Butyl-, Isooctyl- oder Hydroxyethylacrylat, Methyl- oder Ethylmethacrylat, Acrylnitril, Acrylamid, N-Butyl(methacrylamid); sowie Vinyl- und Allylverbindungen wie z.B. Vinylacetat, Vinylstearat, N-Vinylpyrrolidon, Vinylidenchlorid, Vinylbenzol oder Allylacetat.

Beispiele mehrfach ungesättigter Verbindungen sind Acrylate, Methacrylate oder Itaconate von Polyolen wie z.B. Ethylenglykoldiacrylat, Diethylenglykol-dimethacrylat, Triethylenglykol-diacrylat, Butandiol-1,4-diacrylat, Propandiol-1,2-diacrylat, Butandiol-1,3-dimethacrylat, Neopentylglykol-diacrylat, Trimethylolpropan-di-(meth)acrylat, Trimethylolethan-di(meth)acrylat, Glycerin-di-und -triacrylat, Pentaerythrit-di-, -tri- und - tetraacrylat oder -methacrylat, Dipentaerythrit-tetra, -penta- und -hexaacrylat oder -methacrylat oder -itaconat, Sorbit-tetraacrylat, Sorbit-hexamethacrylat, Diacrylate oder Dimethacrylate von 1,4-Cyclohexandiol, 1,4-Dimethylolcyclohexan, Bisphenol A, 2,2-Bis(4-hydroxyphenyl)propan von Polyethylenglykolen oder von Oligoestern oder Oligourethanen mit endständigen Hydroxylgruppen. Als mehrfach ungesättigte Monomere können auch Acrylamide verwendet werden wie z.B. Methylen-bisacrylamid, Hexamethylen-1,6-bisacrylamid, Diethylentriamin-tris-methacrylamid, Bis(methacrylamidopropoxy)ethan oder 2-Acrylamido-ethylacrylat. Beispiele für mehrfach ungesättigte Vinyl- und Allylverbindungen sind Divinylbenzol, Ethylenglykoldivinylether, Diallylphthalat, Allylmethacrylat, Diallylmaleat, Triallylisocyanurat oder Triallylphosphat.

Auch polymere oder oligomere mehrfach ungesättigte Verbindungen lassen sich unter Vernetzung photopolymerisieren wie z.B. ungesättigte Polyester und Copolyester der Maleinsäure und Fumarsäure, (Meth)acrylate von Polyvinylalkohol oder Homo- oder Copolymerisate von Butadien oder Isopren. Weitere verwendbare mehrfach ungesättigte Komponenten sind die Umsetzungsprodukte von Polyepoxiden mit Acryl-oder Methacrylsäuren. Als Polyepoxide werden dabei vorwiegend die im Handel erhältlichen

Epoxidharz-Vorprodukte verwendet, die in verschiedenen Molekulargewichten erhältlich sind.

Meist werden zur Photopolymerisation Gemische solcher ungesättigter Verbindungen verwendet, um die Eigenschaften der Polymerisate für den gewünschten Verwendungszweck variieren zu können. Beispiele hierfür sind Gemische von Diacrylaten mit Polyester-acrylaten oder mit Polyurethan-acrylaten, Gemische von Mono-, Di- und Triacrylaten, Gemische von ungesättigen Polyestern der Maleinsäure mit Styrol oder andere Gemische von polymer-oligomeren ungesättigten Verbinddungen mit Di-, Tri- oder Tetraacrylaten. Die Gemische können aus zwei, drei oder auch mehreren ungesättigten Komponenten bestehen.

Photohärtbare Zusammensetzungen, wie sie für die verschiedenen Zwecke verwendet werden, enthalten meist ausser den photopolymerisierbaren Verbindungen und den Photoinitiatoren eine Reihe sonstiger Zusätze. So ist es vielfach üblich, thermische Inhibitoren zususetzen, die vor allem während der Herstellung der Gemische durch Mischen der Komponenten vor einer vorzeitigen Polymerisation schützen sollen. Hierzu werden beispielsweise Hydrochinon, Hydrochinonderivate, p-Methoxyphenol, $\beta$-Naphthole oder sterisch gehinderte Phenole wie z.B. 2,6-Di(tert-butyl)-p-kresol verwendet. Weiter können geringe Mengen von UV-Absorbern zugesetzt werden wie z.B. solche vom Benztriazol-, Benzophenon- oder Oxalanilid-Typ. Ebenso lassen sich Lichtschutzmittel vom Typus sterisch gehinderter Amine (HALS) zusetzen.

Zur Erhöhung der Dunkellagerstabilität können Kupferverbindungen wie Kupfernaphthenat, -stearat, oder-octoat, Phosphorverbindungen wie Triphenylphosphin, Tributylphosphin, Triäthylphosphit, Triphenylphosphit oder Tribenzylphosphit, quaternäre Ammoniumverbindungen wie Tetramethylammoniumchlorid oder Trimethyl-benzylammoniumchlorid oder Hydroxyaminderivate, wie z.B. N-Diäthylhydroxylamin, zugesetzt werden.

Die photohärtbaren Zusammensetzungen können auch polymere Bindemittel enthalten, die keine ungesättigten Verbindungen sind. Beispiele hierfür sind Polyacrylate, Celluloseester und -ether, Polyvinylester, Vinylchlorid-polymerisate, Polyamide, Polyester, Polyether oder Styrol-Maleinsäureanhydrid-Copolymere. Weitere übliche Zusatzstoffe sind Pigmente, Farbstoffe, Füllstoffe, Haftvermittler, Netzmittel oder Verlaufsmittel. Für bestimmte Applikationen können auch Lösungsmittel zugesetzt werden. Vorzugsweise werden jedoch keine Lösungsmittel verwendet.

Weitere übliche Zusätze sind Photosensibilisatoren, welche in bestimmten Wellenlängen absorbieren und die absorbierte Energie an die Initiatoren weitergeben oder selbst als zusätzlicher Initiator fungieren. Beispiele hierfür sind vor allem Thioxanthon-, Anthracen-, Anthrachinon- und Cumarinderivate.

Weitere übliche Zusätze sind Beschleuniger vom Amin-Typ, die vor allem in pigmentierten Zubereitungen von Bedeutung sind, da sie als Kettenüberträger wirken. Beispiele hierfür sind N-Methyldiethanolamin, Triethylamin, p-Dimethylaminobenzoesäureethylester oder Michler's Keton.

Gegenstand der Erfindung sind daher auch photohärtbare Zusammensetzungen enthaltend mindestens eine ethylenisch ungesättigte Verbindung und 0,5 bis 20 Gew.-%, insbesondere 1-5 Gew.-%, eines Initiatorgemisches gemäss Anspruch 1.

Die erfindungsgemässen photohärtbaren Zusammensetzungen eignen sich als Beschichtungsmittel für Substrate aller Art, z.B. Holz, Papier, Keramik, Kunststoffe wie Polyester- und Celluloseacetatfilme und Metalle wie Kupfer und Aluminium, bei denen durch Photopolymerisation eine Schutzschicht oder eine Abbildung aufgebracht werden soll.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Druckfarben von Bedeutung.

Gut geeignet sind die erfindungsgemässen photohärtbaren Gemische auch zur Herstellung von Druckplatten. Beispiele sind feste Druckplatten für den Buch- und Zeitungsdruck sowie flexible Druckplatten für den sog. Flexodruck. Hierbei werden z.B. Gemische von löslichen linearen Polyamiden mit photopolymerisierbaren Monomeren, beispielsweise Acrylamiden, und einem Photoinitiator verwendet. Filme und Platten aus diesen Systemen werden über das Negativ (oder Positive) der Druckvorlage belichtet und die ungehärteten Anteile anschliessend mit einem Lösungsmittel eluiert.

Ein weiteres Einsatzgebiet der Photohärtung ist die Metallbeschichtung, beispielsweise bei der Lackierung von Blechen für Tuben, Dosen oder Flaschenverschlüssen, sowie die Photohärtung von Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplatten-Hüllen oder Buchumschlägen.

Wichtig ist auch die Verwendung der photohärtbaren Zusammensetzungen für Abbildungsverfahren und zur optischen Herstellung von Informationsträgern. Hierbei wird die auf dem Träger aufgebrachte Schicht durch eine Photomaske mit Licht bestrahlt und die unbelichteten Stellen der Schicht durch Behandlung mit einem Lösungsmittel (= Entwickler) entfernt. Die belichteten Stellen sind vernetztpolymer und dadurch

unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte Schaltungen und Photoresists herstellen.

Zur Belichtung eignen sich vor allem Lichtquellen mit hohem Anteil an kurzwelligem Licht. Hierfür stehen heute entsprechende technische Vorrichtungen und verschiedene Lampenarten zur Verfügung. Beispiele sind Kohlelichtbogenlampen, Xenonlichtbogenlampen, Quecksilberdampflampen, Metall-Halogenlampen, Fluoreszenzlampen, Argonglühlampen oder photographische Flutlichtlampen. Neuerdings werden auch Laserlichtquellen verwendet. Diese lassen sich auch ohne Photomasken einsetzen; der gesteuerte Laserstrahl schreibt dann direkt auf die photohärtbare Schicht. Bei Verwendung als Aussenanstrich ist auch eine Härtung durch Sonnenlicht möglich.

Die folgenden Beispiele erläutern die Zubereitung und die Verwendung der Initiatorgemische näher. Teile und Prozent beziehen sich darin auf das Gewicht, sofern nichts anderes angegeben wird.

Beispiel 1: Photohärtung eines Acrylatgemisches

Alle Operationen werden unter Rot- oder Gelblicht durchgeführt.
Eine photohärtbare Masse wird bereitet durch Mischen von

50 Teilen eines oligomeren Urethanacrylates (®Actilane AJ 20 von SNPE)
10 Teilen Trimethylolpropan-triacrylat,
10 Teilen Dipentaerythrit-monohydroxy-pentaacrylat,
15 Teilen Tripropylenglykol-diacrylat,
15 Teilen N-Vinylpyrrolidon und
0,5 Teilen eines Verlaufhilfsmittels auf Silicon-Basis (®Byk 300 von Byk Mallinckrodt)

Portionen dieser Mischung werden mit den in Tabelle 1 angegebenen Photoinitiatoren vermischt. Die Proben werden in einer Schichtdicke von 100 µm auf entfettete Aluminiumbleche (200 µm) aufgetragen. Auf die flüssige Schicht wird eine 76 µm dicke Polyesterfolie gelegt, darauf als Photomaske ein 21 Stufen-Stouffer-Testnegativ sowie ein zweiter Polyesterfilm, der grösser als das Aluminiumblech ist. Das so erhaltene Laminat wird auf eine mit Bohrungen versehene Metallplatte gelegt und durch Vakuum darauf fixiert.

Die Proben werden 5 Sekunden mit einer 5 kW-Metallhalogenid-Lampe im Abstand von 30 cm belichtet. Nach Entfernung der Polyesterfolien und des Testnegativs wird die Probe 15 s in einem Ethanolbad entwickelt, wobei die ungehärteten Anteile gelöst werden. Dann wird die Probe 5 min bei 60 °C getrocknet.

Die Empfindlichkeit des verwendeten Initiatorsystems wird durch Angabe der höchsten klebefrei abgebildeten Stufe beurteilt. Je höher die Stufe, desto empfindlicher ist das System. Eine Erhöhung um zwei Stufen bedeutet dabei etwa eine Verdopplung der Härtungsgeschwindigkeit.

Folgende Photoinitiatoren werden verwendet:

A-1 2-Hydroxy-2-methyl-1-phenylpropanon-1
A-2 1-Hydroxycyclohexyl-phenyl-keton
A-3 Benzophenon

A-4 Benzil-dimethylketal

B-1 Bis(methylcyclopentadienyl)-bis(4-decyloxy-2,3,5,6-tetrafluorphenyl)-titan

Tabelle 1

| Menge Photoinitiator *) Komponente A | Komponente B | Maximale Abbildungsstufe |
|---|---|---|
| 2 % A-1 | -- | 5 |
| 1,95 % A-1 | 0,05 % B-1 | 7 |
| 1,9 % A-1 | 0,1 % B-1 | 8 |
| 1,8 % A-1 | 0,2 % B-1 | 10 |
| 1 % A-2 + 1 % A-3 | -- | 3 |
| 0,98 % A-2 + 0,98 % A-3 | 0,04 % B-1 | 6 |
| 1 % A-2 + 1 % A-3 | -- | 3 |
| 2 % A-4 | -- | 7 |
| 0,5 % A-2 + 0,5 % A-3 + 0,95 % A-4 | 0,05 % B-1 | 9 |

*) bezogen auf die photohärtbare Zusammensetzung

Man ersieht daraus, dass die Kombination von A und B eine höhere Empfindlichkeit bewirkt als die einzelnen Komponenten oder die Kombination verschiedener A-Typ-Initiatoren.

Beispiel 2

Es wird wie in Beispiel 1 vorgegangen, die Proben wurden jedoch 5 und 10 Sekunden belichtet. Folgende Photoinitiatoren werden verwendet:

A-5 2-Hydroxy-2-methyl-1-(p-chlorphenyl)-propanon-1

A-6 2-Hydroxy-2-methyl-1-(p-methoxyphenyl)-propanon-1

A-7 2-Hydroxy-2-methyl-1-(p-isopropylphenyl)-propanon-1

A-8 2-(Dimethylamino)-2-methyl-1-(p-chlorphenyl)-propanon-1

A-9 2-(3,5-Dimethylmorpholino)-2-methyl-1-(p-methoxyphenyl)-propanon-1

A-10 2-(Dimethylamino)-2-methyl-1-(p-methylthiophenyl)-pentanon-1

B-2 Bis(cyclopentadienyl)-2-trifluormethylphenyl-titan-trifluoracetat

Tabelle 2

| Menge Photoinitiator *) Komponente A | Komponente B | Maximale Abbildungsstufe 5 sec | 10 sec |
|---|---|---|---|
| 2 % A-5 | -- | 4 | 6 |
| 1,95 % A-5 | 0,05 % B-2 | 6 | 8 |
| 2 % A-6 | -- | 2 | 4 |
| 1,95 % A-6 | 0,05 % B-2 | 4 | 6 |
| 2 % A-7 | -- | 3 | 5 |
| 1,95 % A-7 | 0,05 % B-2 | 5 | 7 |
| 2 % A-8 | -- | 0 | 1 |
| 1,95 % A-8 | 0,05 % B-2 | 3 | 5 |
| 2 % A-9 | -- | 4 | 6 |
| 1,95 % A-9 | 0,05 % B-2 | 5 | 7 |
| 2 % A-10 | -- | 3 | 6 |
| 1,95 % A-10 | 0,05 % B-2 | 5 | 7 |

*) bezogen auf die photohärtbare Zusammensetzung

Beispiel 3

Es wird wie in Beispiel 2 vorgegangen. Ausser den in Beispiel 1 und 2 beschriebenen Initiatoren werden folgende Photoinitiatoren verwendet:

B-3 Bis(methylcyclopentadienyl)-bis(2,6-difluor-3-methylphenyl)-titan

B-4 Bis(methylcyclopentadienyl)-bis(2,6-difluorphenyl)-titan

B-5 Bis(methylcyclopentadienyl)-2-trifluormethylphenyl-titan-trifluoracetat

B-6 Bis(cyclopentadienyl)-bis(2,6-difluor-3-butoxyphenyl)-titan

B-7 Bis(cyclopentadienyl)-bis(4-decyloxy-2,3,5,6-tetrafluorphenyl)-titan

B-8 Bis(cyclopentadienyl)-bis[2,6-difluor-3-(2-ethoxyethoxy)-phenyl]-titan

Tabelle 3

| Menge Photoinitiator *) Komponente A | Komponente B | Maximale Abbildungsstufe 5 sec | 10 sec |
|---|---|---|---|
| 1 % A-2 + 1 % A-3 | -- | 3 | 5 |
| 0,975 % A-2 + 0,975 % A-3 | 0,05 % B-1 | 6 | 8 |
| 0,975 % A-2 + 0,975 % A-3 | 0,05 % B-2 | 6 | 8 |
| 0,975 % A-2 + 0,975 % A-3 | 0,05 % B-3 | 7 | 10 |
| 0,975 % A-2 + 0,975 % A-3 | 0,05 % B-4 | 7 | 10 |
| 0,975 % A-2 + 0,975 % A-3 | 0,05 % B-5 | 5 | 7 |
| 0,975 % A-2 + 0,975 % A-3 | 0,05 % B-6 | 9 | 12 |
| 0,975 % A-2 + 0,975 % A-3 | 0,05 % B-7 | 8 | 11 |
| 0,975 % A-2 + 0,975 % A-3 | 0,05 % B-8 | 9 | 12 |

*) bezogen auf die photohärtbare Zusammensetzung

## Ansprüche

1. Flüssiges Photoinitiatorgemisch bestehend aus
A) 70-99,9 Gew.-% mindestens eines flüssigen Photoinitiators der Formel I oder eines flüssigen Gemisches aus metallfreien Photoinitiatoren enthaltend mindestens eine Verbindung der Formel I,

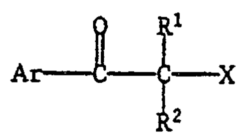

(I)

worin Ar eine unsubstituierte oder durch einen oder mehrere der Substituenten Halogen, $C_1$-$C_{18}$-Alkyl, $C_3$-$C_{12}$-Alkenyl, $C_1$-$C_{12}$-Alkoxy, Allyloxy, Phenoxy, $C_1$-$C_{18}$-Alkylthio, Allylthio, 2-Hydroxyethylthio, Phenylthio, Tolylthio, $C_1$-$C_{12}$-Alkylamino, $C_2$-$C_{12}$-Alkylamino, $C_2$-$C_{24}$-Dialkylamino, $C_4$-$C_8$-Bis(hydroxyalkyl)-amino, Diallylamino, Bis(2-methoxyethyl)amino, Morpholino, Piperidino oder Pyrrolidino substituierte Phenylgruppe bedeutet,
$R^1$ und $R^2$ unabhängig voneinander $C_1$-$C_{18}$-Alkyl oder durch -OH, $C_1$-$C_4$-Alkoxy, Benzyloxy, -CN, -COO($C_1$-$C_8$-Alkyl), ($C_1$-$C_4$-Alkyl)-COO-, $C_2$-$C_8$-Dialkylamino oder Morpholino substituiertes $C_1$-$C_4$-Alkyl bedeuten oder $R^1$ und $R^2$ zusammen $C_3$-$C_9$-Alkandiyl, $C_3$-$C_9$-Oxa- oder Azaalkandiyl oder $C_5$-$C_9$-Alkendiyl bedeuten,
X eine Gruppe $-OR^3$ oder $-NR^4R^5$ bedeutet, worin
$R^3$ Wasserstoff, $C_1$-$C_8$-Alkyl, durch Halogen, -OH oder $C_1$-$C_4$-Alkoxy substituiertes $C_2$-$C_4$-Alkyl, Allyl, Benzyl, 2-Tetrahydropyranyl, Trimethylsilyl oder Phenyl-dimethylsilyl bedeutet,
$R^4$ und $R^5$ unabhängig voneinander Wasserstoff, $C_1$-$C_{12}$-Alkyl, durch -OH, $C_1$-$C_4$-Alkoxy-, -CN oder -COO($C_1$-$C_4$-Alkyl) substituiertes $C_2$-$C_4$-Alkyl, Allyl, Benzyl oder Cyclohexyl bedeuten oder $R^4$ und $R^5$ zusammen $C_3$-$C_7$-Alkylen, das durch -O- oder $-N(R^6)$- unterbrochen sein kann, bedeuten, worin $R^6$ Wasserstoff, $C_1$-$C_4$-Alkyl, Allyl, Benzyl oder $C_2$-$C_4$-Hydroxyalkyl bedeutet, und
B) 0,1-30 Gew.-% mindestens eines Titanocen-Photoinitiators, ausgewählt aus

$B_1$) Verbindungen der Formel II

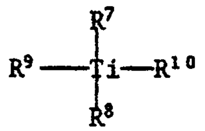

(II)

worin $R^7$ und $R^8$ unabhängig voneinander ein unsubstituiertes oder durch $C_1$-$C_4$-Alkyl, Chlor, Phenyl oder Cyclohexyl substituiertes Cyclopentadienyl- oder Indenyl-Anion bedeuten oder $R^7$ und $R^8$ zusammen ein zweiwertiges Bis-cyclopentadienyl-Anion der Formel III bedeuten,

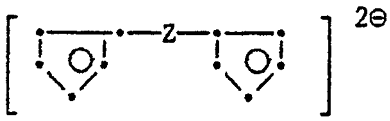

(III)

worin Z Methylen, Di- oder Trimethylen, $C_2$-$C_{12}$-Alkyliden, $C_5$-$C_7$-Cycloalkyliden, -Si($R^{11}$)($R^{12}$)- oder -Sn($R^{11}$)$_2$- bedeutet und
$R^{11}$ und $R^{12}$ $C_1$-$C_{12}$-Alkyl, Phenyl oder Benzyl bedeuten,
$R^9$ den einwertigen Rest eines 6-gliedrigen carbocyclischen oder 5-oder 6-gliedrigen heterocyclischen aromatischen Ringes bedeutet, der in mindestens einer ortho-Position zur Bindung an das Ti-Atom durch Fluor substituiert ist und ausserdem durch eine oder mehrere der Substituenten Halogen, $C_1$-$C_{12}$-Alkyl, $C_1$-$C_{14}$-Alkoxy, $-O(CH_2CH_2O)_{\overline{1-20}}$ $C_1$-$C_{14}$-Alkyl, $C_2$-$C_{10}$-Alkoxycarbonyl, Aminocarbonyl mit bis zu 12 C-Atomen oder durch eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen substituiert sein kann,
$R^{10}$ eine der für $R^9$ angegebenen Bedeutungen hat oder $C_2$-$C_{12}$-Alkinyl, unsubstituiertes oder im Phenylrest durch Halogen oder $C_1$-$C_{14}$-Alkyl substituiertes Phenylalkinyl mit 2 - 5 C-Atomen im Alkinrest oder Halogen oder eine Gruppe -Si($R^{11}$)$_3$, -Si($R^{11}$)$_2$($R^{12}$), -Sn($R^{11}$)$_3$, -OH, $C_1$-$C_{10}$-Alkoxy, $C_6$-$C_{10}$-Aryloxy, unsubstituiertes oder durch Halogen substituiertes $C_2$-$C_6$-Acyloxy, $-N_3$, -CN, -NCO oder -NCS bedeutet, oder
$R^9$ und $R^{10}$ zusammen einen Rest der Formel -Q-Y-Q- bedeuten, worin Q ein carbocyclischer oder 5- oder 6-gliedriger heterocyclischer aromatischer Ring ist, der in 2-Stellung zur Y-Gruppe an das Titan-Atom gebunden ist und in 3-Stellung durch Fluor substituiert ist und als weitere Substituenten $C_1$-$C_4$-Alkyl, Halogen, $C_1$-$C_4$-Alkoxy, Di($C_1$-$C_4$-alkyl)amino oder eine quartäre $C_3$-$C_{20}$-Ammoniumgruppe enthalten kann,
Y Methylen, $C_2$-$C_{12}$-Alkyliden, $C_5$-$C_7$-Cycloalkyliden, eine direkte Bindung oder eine Gruppe -$NR^{13}$-, -O-, -S-, -SO-, $-SO_2$-, -CO-, -Si($R^{11}$)($R^{12}$)- oder -Sn($R^{11}$)$_2$- bedeutet und $R^{13}$ Wasserstoff, $C_1$-$C_{12}$-Alkyl, Cyclohexyl, Phenyl, Tolyl oder Benzyl bedeutet, oder

$B_2$) Verbindungen der Formel IV,

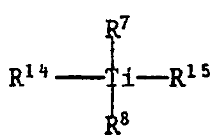

(IV)

worin $R^7$ und $R^8$ die oben genannte Bedeutung haben,
$R^{14}$ den einwertigen Rest eines 6-gliedrigen carbocyclischen oder 5-oder 6-gliedrigen heterocyclischen aromatischen Ringes bedeutet, der in mindestens einer ortho-Position zur Bindung an das Ti-Atom durch $-CF_3$ substituiert ist und ausserdem durch eine oder mehrere der Gruppen Halogen, $C_1$-$C_{12}$-Alkyl, $C_1$-$C_{14}$-Alkoxy, $-O(CH_2CH_2O)_{\overline{1-20}}$ $C_1$-$C_{14}$-Alkyl,$C_2$-$C_{10}$-Alkoxycarbonyl oder Aminocarbonyl oder durch eine primäre, sekundäre oder tertiäre Amino- oder Aminoalkylgruppe mit bis zu 20 C-Atomen oder eine quartäre Ammonium- oder Ammoniumalkylgruppe mit bis zu 30 C-Atomen substituiert sein kann, und
$R^{15}$ eine der für $R^{14}$ gegebenen Bedeutungen hat oder $C_2$-$C_{12}$-Alkinyl, unsubstituiertes oder im Phenylrest durch Halogen oder $C_1$-$C_4$-Alkyl substituiertes Phenylalkinyl mit 2 - 5 C-Atomen im Alkinrest

oder Halogen oder eine Gruppe $-Si(R^{11})_3$, $-Si(R^{11})_2(R^{12})$, $-Sn(R^{11})_3$, -OH, $C_1$-$C_{10}$-Alkoxy, $C_6$-$C_{10}$-Aryloxy, unsubstituiertes oder mit Halogen substituiertes $C_2$-$C_6$-Acyloxy, $-N_3$, -CN, -NCO oder -NCS bedeutet.

**2.** Flüssiges Initiatorgemisch gemäss Anspruch 1, bestehend aus

A) 80-99,5 Gew.-% eines flüssigen Photoinitiators oder Photoinitiatorgemisches enthaltend mindestens eine Verbindung der Formel I, worin

Ar eine unsubstituierte oder durch einen oder zwei der Substituenten Halogen, $C_1$-$C_{12}$-Alkyl, $C_1$-$C_8$-Alkoxy, Allyloxy, Phenoxy, $C_1$-$C_8$-Alkylthio, 2-Hydroxyethylthio, Allylthio, Phenylthio, $C_1$-$C_8$-Alkylamino, $C_2$-$C_{16}$-Dialkylamino, Diallylamino, $C_4$-$C_6$-Bis(hydroxyalkyl)amino, Bis(2-methoxyethyl)amino, Morpholino, Piperidino oder Pyrrolidino substituierte Phenylgruppe bedeutet,

$R^1$ und $R^2$ unabhängig voneinander $C_1$-$C_6$-Alkyl oder durch -OH, $C_1$-$C_4$-Alkoxy, Benzyloxy, $-COO(C_1$-$C_4$-Alkyl), $C_2$-$C_4$-Dialkylamino oder Morpholino substituiertes $C_1$-$C_4$-Alkyl bedeuten oder

$R^1$ und $R^2$ zusammen $C_3$-$C_6$-Alkandiyl oder $C_5$-$C_7$-Alkendiyl bedeuten,

X eine Gruppe $-OR^3$ oder $-NR^4R^5$ bedeutet, worin

$R^3$ Wasserstoff, $C_1$-$C_4$-Alkyl, durch -OH oder $C_1$-$C_4$-Alkoxy substituiertes $C_2$-$C_4$-Alkyl, Allyl, Benzyl, 2-Tetrahydropyranyl oder Trimethylsilyl bedeutet und $R^4$ und $R^5$ unabhängig voneinander Wasserstoff, $C_1$-$C_8$-Alkyl, durch -OH oder $C_1$-$C_4$-Alkoxy substituiertes $C_2$-$C_4$-Alkyl, Allyl, Benzyl oder Cyclohexyl bedeuten oder $R^4$ und $R^5$ zusammen $C_3$-$C_7$-Alkylen bedeuten, das durch -O- oder $-N(R^6)$-unterbrochen sein kann, wobei $R^6$ Wasserstoff, Methyl oder $C_2$-$C_4$-Hydroxyalkyl bedeutet, und

B) 0,5-20 Gew.-% einer Verbindung der Formel II, worin $R^7$ und $R^8$ ein unsubstituiertes oder durch $C_1$-$C_4$-Alkyl substituiertes Cyclopentadienyl-Anion sind und

$R^9$ und $R^{10}$ eine Gruppe der Formel V bedeuten,

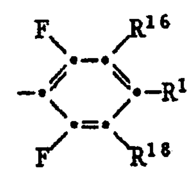

(V)

worin $R^{16}$, $R^{17}$ und $R^{18}$ unabhängig voneinander Wasserstoff, F, Cl, Br, $C_1$-$C_{14}$-Alkoxy, $-O-(CH_2CH_2O)_{1-8}$ $C_1$-$C_{14}$-Alkyl eine tertiäre Aminogruppe oder Aminomethylgruppe mit 2 - 20 C-Atomen oder eine quartäre Ammonium- oder Ammonium-methylgruppe mit 3 - 24 C-Atomen bedeuten oder

$R^9$ und $R^{10}$ zusammen eine zweiwertige Gruppe der Formel

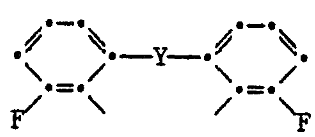

darstellen, worin Y die in Anspruch 1 angegebene Bedeutung hat,

oder 0,5-20 Gew.-% einer Verbindung der Formel IV worin $R^7$ und $R^8$ ein unsubstituiertes oder durch $C_1$-$C_4$-Alkyl substituiertes Cyclopentadienyl-Anion sind und $R^{14}$ eine Gruppe der Formel VI bedeutet,

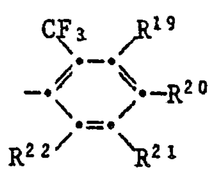

(VI)

worin $R^{19}$, $R^{20}$, $R^{21}$ und $R^{22}$ unabhängig voneinander Wasserstoff, F, Cl, Br oder $C_1$-$C_{14}$-Alkoxy bedeuten und $R^{15}$ eine der für $R^{14}$ gegebenen Bedeutungen hat oder F, Cl, Br, CN, $-O-CO-CH_3$, $-O-CO-CF_3$, $N_3$, -NCO oder -NCS bedeutet.

**3.** Flüssiges Initiatorgemisch gemäss Anspruch 1, dadurch gekennzeichnet, dass die Komponente A ein flüssiges Gemisch ist aus einer Verbindung der Formel I und einer Verbindung der Formel VII,

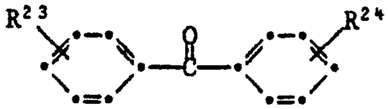

(VII)

worin $R^{23}$ und $R^{24}$ unabhängig voneinander Wasserstoff, $C_1$-$C_{12}$-Alkyl, $C_1$-$C_4$-Alkoxy, $C_1$-$C_4$-Alkylthio, $C_2$-$C_4$-Hydroxyalkyloxy, $C_2$-$C_4$-Hydroxyalkylthio, Halogen, $C_2$-$C_{10}$-Alkoxycarbonyl oder $C_2$-$C_8$-Dialkylamino bedeuten.

4. Flüssiges Initiatorgemisch gemäss Anspruch 3, wobei die Verbindungen der Formel I und der Formel VII im Gewichtsverhältnis von 0,8:1 bis 1:0,8 vorliegen.

5. Flüssiges Initiatorgemisch gemäss Anspruch 1, dadurch gekennzeichnet, dass die Komponente A ein flüssiges Gemisch ist aus einer Verbindung der Formel I und einem 2,4,6-Tri($C_1$-$C_4$-alkyl)benzophenon.

6. Flüssiges Initiatorgemisch gemäss Anspruch 1, dadurch gekennzeichnet, dass die Komponente A ein flüssiges Gemisch ist aus einer Verbindung der Formel I und einer Verbindung der Formel VIII,

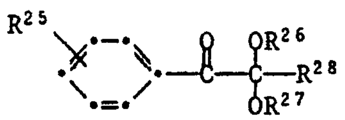

(VIII)

worin $R^{25}$ Halogen, $C_1$-$C_4$-Alkyl oder $C_1$-$C_4$-Alkoxy bedeutet, $R^{26}$ und $R^{27}$ $C_1$-$C_6$-Alkyl, $C_3$-$C_4$-Alkenyl, $C_7$-$C_{10}$-Phenylalkyl oder durch Halogen, $C_1$-$C_4$-Alkoxy, $C_2$-$C_8$-Dialkylamino, Morpholino oder Piperidino substituiertes $C_2$-$C_4$ Alkyl bedeuten oder $R^{26}$ und $R^{27}$ zusammen $C_2$-$C_{12}$-Alkandiyl oder 2-Buten-1,4-diyl bedeuten und $R^{28}$ Wasserstoff, $C_1$-$C_8$Alkyl, $C_5$-$C_8$-Cycloalkyl, Phenyl oder durch Halogen, $C_1$-$C_4$-Alkyl oder $C_1$-$C_4$-Alkoxy substituiertes Phenyl bedeutet.

7. Flüssiges Initiatorgemisch gemäss Anspruch 6, wobei die Verbindungen der Formel I und Formel VIII im Gewichtsverhältnis von 2:1 bis 1:2 vorliegen.

8. Flüssiges Initiatorgemisch gemäss Anspruch 1, dadurch gekennzeichnet, dass die Komponente A ein flüssiges Gemisch ist aus einer Verbindung der Formel I, einer Verbindung der Formel VII und einer Verbindung der Formel VIII.

9. Flüssiges Initiatorgemisch gemäss Anspruch 1, dadurch gekennzeichnet, dass die Komponente A eine Verbindung der Formel I enthält, worin Ar Phenyl oder durch Chlor, Fluor, $C_1$-$C_{12}$-Alkyl, Methoxy, Methylthio, Dimethylamino, Diethylamino, Bis(2-methoxyethyl)amino, Morpholino, Piperidino oder Pyrrolidino substituiertes Phenyl bedeutet, $R^1$ und $R^2$ unabhängig voneinander $C_1$-$C_4$-Alkyl oder durch -OH oder $C_1$-$C_4$-Alkoxy substituiertes $C_1$-$C_4$-Alkyl bedeuten oder $R^1$ und $R^2$ zusammen $C_4$-$C_6$-Alkandiyl oder $C_5$-$C_7$-Alkendiyl bedeuten und X -OH oder $-NR^4R^5$ ist, wobei $R^4$ und $R^5$ $C_1$-$C_4$-Alkyl, Allyl oder 2-Methoxyethyl bedeuten oder $R^4$ und $R^5$ zusammen mit dem Stickstoffatom Pyrrolidino, Piperidino, Morpholino, Piperazino oder 4-Methylpiperazino bedeuten.

10. Flüssiges Initiatorgemisch gemäss Anspruch 1, dadurch gekennzeichnet, dass die Komponente A eine Verbindung der Formel I enthält, worin Ar, Phenyl, p-Tolyl, p-Cumyl, 4-Dodecylphenyl, 4-Chlorphenyl oder 4-Methoxyphenyl bedeutet, $R^1$ und $R^2$ unabhängig voneinander $C_1$-$C_4$-Alkyl oder $R^1$ und $R^2$ zusammen Tetra-oder Pentamethylen bedeuten und X eine Hydroxylgruppe ist.

11. Flüssiges Initiatorgemisch gemäss Anspruch 1, dadurch gekennzeichnet, dass die Komponente A eine Verbindung der Formel I enthält, worin Ar Phenyl, p-Tolyl, p-Cumyl, 4-Chlorphenyl, 4-Methoxyphenyl, 4-Methylthiophenyl, 4-Dimethylaminophenyl, 4-Diethylaminophenyl, 4-Bis(2-methoxyethyl)amino-phenyl, 4-Morpholinophenyl oder 4-Piperidinophenyl bedeutet, $R^1$ und $R^2$ unabhängig voneinander $C_1$-$C_4$-Alkyl bedeuten und X Methylamino, Dimethylamino, Ethylamino, Diethylamino, Bis(2-methoxyethyl)amino, Piperidino, Pyrrolidino, Morpholino, Piperazino oder 4-Methylpiperazino bedeutet.

**12.** Flüssiges Initiatorgemisch gemäss Anspruch 1, dadurch gekennzeichnet, dass die Komponente B entweder eine Verbindung der Formel II ist, worin $R^7$ und $R^8$ ein Cyclopentadienyl-oder Methylcyclopentadienyl-Anion sind und $R^9$ und $R^{10}$ eine Gruppe der Formel V sind, worin entweder a) $R^{16}$ H, F, Cl oder Br ist, $R^{17}$ Fluor, $C_1$-$C_{14}$-Alkoxy oder $-O-(CH_2CH_2O)_{\overline{1-6}}$ $C_1$-$C_{14}$-Alkyl ist und $R^{18}$ H, Cl oder Br ist oder b) $R^{18}$ H, F, Cl oder Br ist und $R^{16}$ und $R^{17}$ H, Cl, Br, $C_1$-$C_{14}$-Alkoxy, $-O-(CH_2CH_2O)_{\overline{1-6}}$ $C_1$-$C_{14}$-Alkyl eine tertiäare Amino- oder Aminomethylgruppe oder eine quartäre Ammonium-oder Ammonium-methylgruppe sind, oder B eine Verbindung der Formel IV ist, worin $R^7$ und $R^8$ ein Cyclopentadienyl- oder Methylcyclopentadienyl-Anion sind, $R^{14}$ 2-(Trifluormethyl)phenyl oder 6-Fluor-2-(trifluormethyl)phenyl bedeutet und $R^{15}$ die gleiche Bedeutung wie $R^{14}$ hat oder F, Cl, Br, CN, $N_3$, -O-CO-$CH_3$, -O-CO-$CF_3$, -NCO oder -NCS ist.

**13.** Flüssiges Initiatorgemisch gemäss Anspruch 3, dadurch gekennzeichent, dass die Komponente A ein flüssiges Gemisch aus einer Verbindung der Formel I und Benzophenon ist.

**14.** Flüssiges Initiatorgemisch gemäss Anspruch 1, dadurch gekennzeichnet, dass die Komponente A ein flüssiges Gemisch aus einer Verbindung der Formel I und 2,2-Dimethoxy-2-phenylacetophenon oder 2,2-Diethoxy-2-phenylacetophenon ist.

**15.** Flüssiges Initiatorgemisch gemäss Anspruch 1, bestehend aus
40-50 Gew-.% 1-Hydroxycyclohexyl-phenyl-keton,
40-50 Gew.-% Benzophenon und
2-20 Gew.-% einer Verbindung der Formel II oder IV.

**16.** Flüssiges Initiatorgemisch gemäss Anspruch 15, bestehend aus
40-50 Gew.-% 1-Hydroxycyclohexyl-phenyl-keton,
40-50 Gew.-% Benzophenon und
2-20 Gew.-% Bis(cyclopentadienyl)-bis(4-decyloxy)-tetrafluorphenyl)-titan.

**17.** Flüssiges Initiatorgemisch gemäss Anspruch 1, bestehend aus
25-30 Gew.-% 1-Hydroxycyclohexyl-phenyl-keton,
25-30 Gew.-% Benzophenon,
35-40 Gew.-% 2,2-Dimethoxy-2-phenylacetophenon und
2-15 Gew.-% einer Verbindung der Formel II oder IV.

**18.** Photohärtbare Zusammensetzung enthaltend mindestens eine ethylenisch ungesättigte Verbindung und 0,5 bis 20 Gew.-% eines Initiatorgemisches gemäss Anspruch 1.

**19.** Photohärtbare Zusammensetzung gemäss Anspruch 18, dadurch gekennzeichnet, dass die Zusammensetzung ein Lack oder eine Druckfarbe ist.

**20.** Photohärtbare Zusammensetzung gemäss Anspruch 18, dadurch gekennzeichnet, dass die Zusammensetzung ein Material zur Herstellung von Druckplatten, Resistmaterialien, Bildaufzeichnungsmaterialien oder sonstigen Informationsträgern ist.

**21.** Photohärtbare Zusammensetzung gemäss Anspruch 20, dadurch gekennzeichnet, dass die Bildaufzeichnung in einem Resist- oder Druckplattenmaterial direkt mit dem gesteuerten Laserstrahl erfolgt.

## Claims

**1.** A liquid photoinitiator mixture, comprising
A) 70-99.9% by weight of at least one liquid photoinitiator of the formula I or of a liquid mixture of metal-free photoinitiators containing at least one compound of the formula I

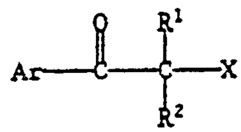 (I)

in which Ar is a phenyl group which is unsubstituted or is monosubstituted or polysubstituted by halogen, $C_1$-$C_{18}$alkyl, $C_3$-$C_{12}$alkenyl, $C_1$-$C_{12}$alkoxy, allyloxy, phenoxy, $C_1$-$C_{18}$alkylthio, allylthio, 2-hydroxyethylthio, phenylthio, tolylthio, $C_1$-$C_{12}$alkylamino, $C_2$-$C_{24}$dialkylamino, $C_4$-$C_8$bis(hydroxyalkyl)-amino, diallylamino, bis(2-methoxyethyl)amino, morpholino, piperidino or pyrrolidino, $R^1$ and $R^2$ independently of one another are $C_1$-$C_8$alkyl or $C_1$-$C_4$alkyl which is substituted by -OH, $C_1$-$C_4$alkoxy, benzyloxy, -CN, -COO($C_1$-$C_8$alkyl), ($C_1$-$C_4$alkyl)-COO-, $C_2$-$C_8$diallamino or morpholino, or $R^1$ and $R^2$ together are $C_3$-$C_9$alkanediyl, $C_3$-$C_9$oxa- or -aza-alkanediyl or $6_5$-$C_9$alkenediyl, X is a group $-OR^3$ or $-NR^4R^5$, in which $R^3$ is hydrogen, $C_1$-$C_8$alkyl, $C_2$-$C_4$alkyl which is substituted by halogen, -OH or $C_1$-$C_4$alkoxy, allyl, benzyl, 2-tetrahydropyranyl, trimethylsilyl or phenyl-dimethylsilyl, $R^4$ and $R^5$ independently of one another are hydrogen, $C_1$-$C_{12}$-alkyl, $C_2$-$C_4$alkyl which is substituted by -OH, $C_1$-$C_4$alkoxy, -CN or -COO($C_1$-$C_4$alkyl), allyl, benzyl or cyclohexyl, or $R^4$ and $R^5$ together are $C_3$-$C_7$alkylene which can be interrupted by -O- or $-N(R^6)-$, $R^6$ being hydrogen, $C_1$-$C_4$alkyl, allyl, benzyl or $C_2$-$C_4$hydroxyalkyl,

and

B) 0.1-30% by weight of at least one titanocene photoinitiator, selected from

$B_1$) compounds of the formula II

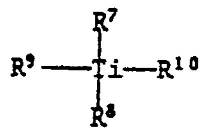 (II)

in which $R^7$ and $R^8$ independently of one another are a cyclopentadienyl or indenyl anion which is unsubstituted or is substituted by $C_1$-$C_4$alkyl, chlorine, phenyl or cyclohexyl, or $R^7$ and $R^8$ together are a divalent biscyclopentadienyl anion of the formula III

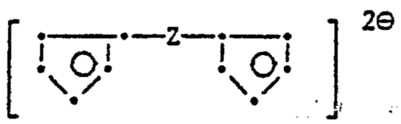 (III)

in which Z is methylene, dimethylene or trimethylene, $C_2$-$C_{12}$alkylidene, $C_5$-$C_7$cycloalkylidene, $-Si(R^{11})(R^{12})-$ or $-Sn(R^{11})_2-$ and $R^{11}$ and $R^{12}$ are $C_1$-$C_{12}$alkyl, phenyl or benzyl, $R^9$ is the monovalent radical of a 6-membered carbocyclic or 5-membered or 6-membered heterocyclic aromatic ring which is substituted by fluorine in at least one ortho-position relative to the bond to the Ti atom and can also be monosubstituted or polysubstituted by halogen, $C_1$-$C_{12}$alkyl, $C_1$-$C_{14}$alkoxy, $-O(CH_2CH_2O)_{\overline{1-20}}$ -$C_1$-$C_1$-$_4$alkyl, $C_2C_{10}$alkoxycarbonyl, aminocarbonyl having up to 12 C atoms or by a primary, secondary or tertiary amino or aminoalkyl group having up to 20 C atoms or a quaternary ammonium or ammonium alkyl group having up to 30 C atoms, $R^{10}$ is as defined for $R^9$ or is $C_2$-$C_{12}$alkynyl, phenylalkynyl which has 2-5 C atoms in the alkyne radical and is unsubstituted or substituted in the phenyl radical by halogen or $C_1$-$C_{14}$-alkyl, or is halogen or a group $-Si(R^{11})_3$, $-Si(R^{11})_2(R^{12})$ or $-Sn(R^{11})_3$, -OH, $C_1$-$C_{10}$alkoxy, $C_6$-$C_{10}$aryloxy, $C_2$-$C_6$acyloxy which is unsubstituted or substituted by halogen, or is $-N_3$, -CN, -NCO or -NCS, or $R^9$ and $R^{10}$ together are a radical of the formula -Q-Y-Q, in which Q is a carbocyclic or 5-membered or 6-membered heterocyclic aromatic ring which is bonded to the titanium atom in the 2-position relative to the Y group and is substituted by fluorine in the 3-position and, as further substituents, can contain $C_1$-$C_4$alkyl, halogen, $C_1$-$C_4$alkoxy, di($C_1$-$C_4$alkyl)amino or a quaternary $C_3$-$C_{20}$ammonium group, Y is methylene, $C_2$-$C_{12}$alkylidene, $C_5$-$C_7$cycloalkylidene, a direct bond or a group $-NR^{13}-$, -O-, -S-, -SO-, $-SO_2-$, -CO, $-Si(R^{11})(R^{12})-$ or $-Sn(R^{12})_2-$ and $R^{13}$ is hydrogen, $C_1$-$C_{12}$alkyl, cyclohexyl, phenyl, tolyl or benzyl, or

$B_2$) compounds of the formula IV

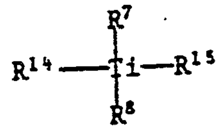

(IV)

in which $R^7$ and $R^8$ are as defined above, $R^{14}$ is the monovalent radical of a 6-membered carbocyclic or 5-membered or 6-membered heterocyclic aromatic ring which is substituted by $-CF_3$ in at least one ortho-position relative to the bond to the Ti atom and can also be monosubstituted or polysubstituted by halogen, $C_1$-$C_{12}$alkyl, $C_1$-$C_{14}$alkoxy, $-O(CH_2CH_2O)_{1-20}$ $-C_1$-$C_{14}$alkyl, $C_2$-$C_{10}$alkoxycarbonyl or aminocarbonyl or by a primary, secondary or tertiary amino or aminoalkyl group having up to 20 C atoms or a quaternary ammonium or ammonium alkyl group having up to 30 C atoms, and $R^{15}$ is as defined for $R^{14}$ or is $C_2$-$C_{12}$alkynyl, phenylalkynyl which has 2-5 C atoms in the alkyne radical and is unsubstituted or substituted in the phenyl radical by halogen or $C_1$-$C_4$alkyl, or is halogen or a group $-Si(R^{11})_3$, $-Si(R^{11})_2(R^{12})$, $-Sn(R^{11})_3$, -OH, $C_1$-$C_{10}$alkoxy, $C_6$-$C_{10}$aryloxy, unsubstituted or halogen-substituted $6_2$-$C_6$acyloxy, $-N_3$, -CN, -NCO or -NCS.

**2.** A liquid initiator mixture according to claim 1, comprising

A) 80-99.5% by weight of a liquid photoinitiator or photoinitiator mixture containing at least one compound of the formula I, in which Ar is a phenyl group which is unsubstituted or is monosubstituted or disubstituted by halogen, $C_1$-$C_{12}$alkyl, $C_1$-$C_8$alkoxy, allyloxy, phenoxy, $C_1$-$C_8$alkylthio, 2-hydroxyethylthio, allylthio, phenylthio, $C_1$-$C_8$alkyl-amino, $C_2$-$C_{16}$dialkylamino, diallylamino, $C_4$-$C_6$bis-(hydroxyalkyl)amino, bis(2-methoxyethyl)amino, morpholino, piperidino or pyrrolidino, $R^1$ and $R^2$ independently of one another are $C_1$-$C_6$alkyl or $C_1$-$C_4$alkyl which is substituted by -OH, $C_1$-$C_4$alkoxy, benzyloxy, $-COO(C_1$-$C_4$alkyl), $C_2$-$C_4$-dialkylamino or morpholino or $R^1$ and $R^2$ together are $C_3$-$C_6$alkanediyl or $C_5$-$C_7$alkenediyl, X is a group $-OR^3$ or $-NR^4R^5$, in which $R^3$ is hydrogen, $C_1$-$C_4$alkyl, $C_2$-$C_4$alkyl which is substituted by -OH or $C_1$-$C_4$alkoxy, allyl, benzyl, 2-tetrahydropyranyl or trimethylsilyl, and $R^4$ and $R^5$ independently of one another are hydrogen, $C_1$-$C_8$alkyl, $C_2$-$C_4$alkyl which is substituted by -OH or $C_1$-$C_4$alkoxy, allyl, benzyl or cyclohexyl, or $R^4$ and $R^5$ together are $C_3$-$C_7$alkylene which can be interrupted by -O- or $-N(R^6)$-, $R^6$ being hydrogen, methyl or $C_2$-$C_4$hydroxyalkyl, and

B) 0.5-20% by weight of a compound of the formula II, in which $R^7$ and $R^8$ are a cyclopentadienyl anion which is unsubstituted or substituted by $C_1$-$C_4$alkyl and $R^9$ and $R^{10}$ are a group of the formula V

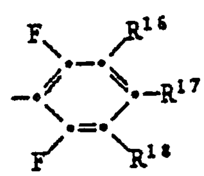

(V)

in which $R^{16}$, $R^{17}$ and $R^{18}$ independently of one another are hydrogen, F, Cl, Br, $C_1$-$C_{14}$alkoxy, $-O-(CH_2CH_2O)_{1-8}$ $-C_1$-$C_{14}$alkyl, a tertiary amino group or aminomethyl group having 2-20 C atoms or a quaternary ammonium or ammonium-methyl group having 3-24 C atoms, or $R^9$ and $R^{10}$ together are a divalent group of the formula

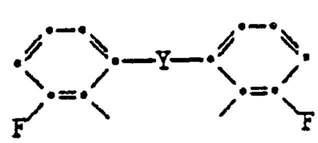

in which Y is as defined in claim 1, or 0.5-20% by weight of a compound of the formula IV, in which $R^7$ and $R^8$ are a cyclopentadienyl anion which is unsubstituted or substituted by $C_1$-$C_4$alkyl and $R^{14}$ is a group of the formula VI

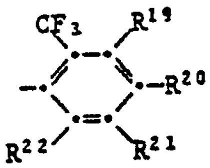

(VI)

in which $R^{19}$, $R^{20}$, $R^{21}$ and $R^{22}$ independently of one another are hydrogen, F, Cl, Br or $C_1$-$C_{14}$alkoxy, and $R^{15}$ is as defined for $R^{14}$ or is F, Cl, Br, CN, -O-CO-$CH_3$, -O-CO-$CF_3$, $N_3$, -NCO or -NCS.

3. A liquid initiator mixture according to claim 1, wherein component A is a liquid mixture of a compound of the formula I and a compound of the formula VII

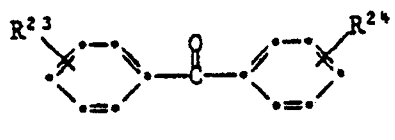

(VII)

in which $R^{23}$ and $R^{24}$ independently of one another are hydrogen, $C_1$-$C_{12}$alkyl, $C_1$-$C_4$alkoxy, $C_1$-$C_4$alkylthio, $C_2$-$C_4$hydroxyalkyloxy, $C_2$-$C_4$-hydroxyalkylthio, halogen, $C_2$-$C_{10}$alkoxycarbonyl or $C_2$-$C_8$dialkylamino.

4. A liquid initiator mixture according to claim 3, wherein the compounds of the formula I and of the formula VII are present in a weight ratio of 0.8:1 to 1:0.8.

5. A liquid initiator mixture according to claim 1, wherein component A is a liquid mixture of a compound of the formula I and a 2,4,6-tri-($C_1$-$C_4$alkyl)-benzophenone.

6. A liquid initiator mixture according to claim 1, wherein component A is a liquid mixture of a compound of the formula I and a compound of the formula VIII

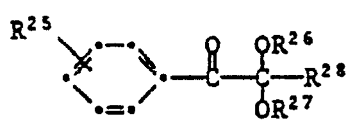

(VIII)

in which $R^{25}$ is halogen, $C_1$-$C_4$alkyl or $C_1$-$C_4$alkoxy, $R^{26}$ and $R^{27}$ are $C_1$-$C_6$alkyl, $C_3$-$C_4$alkenyl, $C_7$-$C_{10}$phenylalkyl or $C_2$-$C_4$alkyl which is substituted by halogen, $C_1$-$C_4$alkoxy, $C_2$-$C_8$dialkylamino, morpholino or piperidino, or $R^{26}$ and $R^{27}$ together are $C_2$-$C_{12}$alkanediyl or 2 -butene-1,4-diyl and $R^{28}$ is hydrogen, $C_1$-$C_8$alkyl, $C_5$-$C_8$cycloalkyl, phenyl or phenyl which is substituted by halogen, $C_1$-$C_4$alkyl or $C_1$-$C_4$alkoxy.

7. A liquid initiator mixture according to claim 6, wherein the compounds of the formula I and of the formula VIII are present in a weight ratio of 2:1 to 1:2.

8. A liquid initiator mixture according to claim 1, wherein component A is a liquid mixture of one compound of the formula I, one compound of the formula VII and one compound of the formula VIII.

9. A liquid initiator mixture according to claim 1, wherein component A contains a compound of the formula I in which Ar is phenyl or phenyl which is substituted by chlorine, fluorine, $C_1$-$C_{12}$alkyl, methoxy, methylthio, dimethylamino, diethylamino, bis(2-methoxyethyl)-amino, morpholino, piperidino or pyrrolidino, $R^1$ and $R^2$ independently of one another are $C_1$-$C_4$alkyl or $C_1$-$C_4$alkyl which is substituted by -OH or $C_1$-$C_4$alkoxy, or $R^1$ and $R^2$ together are $C_4$-$C_6$alkanediyl or $C_5$-$C_7$alkenediyl and X is -OH or -$NR^4R^5$, $R^4$ and $R^5$ being $C_1$-$C_4$alkyl, allyl or 2-methoxy-ethyl or $R^4$ and $R^5$, together with the nitrogen atom, being pyrrolidino, piperidino, morpholino, piperazino or 4-methylpiperazino.

**10.** A liquid initiator mixture according to claim 1, wherein component A contains a compound of the formula I, in which Ar is phenyl, p-tolyl, p-cumyl, 4-dodecylphenyl, 4-chlorophenyl or 4-methoxyphenyl, $R^1$ and $R^2$ independently of one another are $C_1$-$C_4$alkyl or $R^1$ and $R^2$ together are tetramethylene or pentamethylene and X is a hydroxyl group.

**11.** A liquid initiator mixture according to claim 1, wherein component A contains a compound of the formula I, in which Ar is phenyl, p-tolyl, p-cumyl, 4-chlorophenyl, 4-methoxyphenyl, 4-methylthiophenyl, 4-dimethylaminophenyl, 4-diethylaminophenyl, 4-bis(2-methoxyethyl)-amino-phenyl, 4-morpholinophenyl or 4-piperidinophenyl, $R^1$ and $R^2$ independently of one another are $C_1$-$C_4$alkyl and X is methylamino, dimethylamino, ethylamino, diethylamino, bis(2-methoxyethyl)-amino, piperidino, pyrrolidino, morpholino, piperazino or 4-methylpiperazino.

**12.** A liquid initiator mixture according to claim 1, wherein component B is either a compound of the formula II, in which $R^7$ and $R^8$ are a cyclopentadienyl anion or methylcyclopentadienyl anion and $R^9$ and $R^{10}$ are a group of the formula V, in which either a) $R^{16}$ is H, F, Cl or Br, $R^{17}$ is fluorine, $C_1$-$C_{14}$alkoxy or $-O-(CH_2CH_2O)_{\overline{1-6}}$ $C_1$-$C_{14}$alkyl and $R^{18}$ is H, Cl or Br or b) $R^{18}$ is H, F, Cl or Br and $R^{16}$ and $R^{17}$ are H, Cl, Br, $C_1$-$C_{14}$alkoxy, $-O-(CH_2CH_2O)_{\overline{1-6}}$ -$C_1$-$C_{14}$alkyl, a tertiary amino or aminomethyl group or a quaternary ammonium or ammonium-methyl group, or B is a compound of the formula IV, in which $R^7$ and $R^8$ are a cyclopentadienyl anion or methylcyclopentadienyl anion, $R^{14}$ is 2-(trifluoromethyl)-phenyl or 6-fluoro-2-(trifluoromethyl)-phenyl and $R^{15}$ is as defined for $R^{14}$ or is F, Cl, Br, CN, $N_3$, $-O-CO-CH_3$, $-O-CO-CF_3$, -NCO or -NCS.

**13.** A liquid initiator mixture according to claim 3, wherein component A is a liquid mixture of a compound of the formula I and benzophenone.

**14.** A liquid initiator mixture according to claim 1, wherein component A is a liquid mixture of a compound of the formula I and 2,2-dimethoxy-2-phenylacetophenone or 2,2-diethoxy-2-phenylacetophenone.

**15.** A liquid initiator mixture according to claim 1, comprising 40-50% by weight of 1-hydroxycyclohexyl phenyl ketone, 40-50% by weight of benzophenone and 2-20% by weight of a compound of the formula II or IV.

**16.** A liquid initiator mixture according to claim 15, comprising 40-50% by weight of 1-hydroxycyclohexyl phenyl ketone, 40-50% by weight of benzophenone and 2-20% by weight of bis(cyclopentadienyl)-bis-(4-decyloxy-tetrafluorophenyl)-titanium.

**17.** A liquid initiator mixture according to claim 1, comprising 25-30% by weight of 1-hydroxycyclohexyl phenyl ketone, 25-30% by weight of benzophenone, 35-40% by weight of 2,2-dimethoxy-2-phenylacetophenone and 2-15% by weight of a compound of the formula II or IV.

**18.** A photocurable composition, comprising at least one ethylenically unsaturated compound and 0.5 to 20% by weight of an initiator mixture according to claim 1.

**19.** A photocurable composition according to claim 18, which is a surface coating or a printing ink.

**20.** A photocurable composition according to claim 18, which is a material for the production of printing plates, resist materials, image-recording materials or other information carriers.

**21.** A photocurable composition according to claim 20, for image recording in a resist or printing plate material directly by a controlled laser beam.

## Revendications

**1.** Mélange liquide de photo-amorceurs, ce mélange consistant en :

A) 70 à 99,9 % en poids d'au moins un photoamorceur liquide de formule I, ou d'un mélange liquide de photo-amorceurs sans métaux, contenant au moins un composé de formule I :

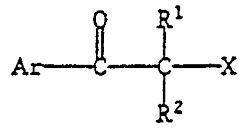

(I)

dans laquelle Ar représente un groupe phényle non substitué ou bien substitué par un ou plusieurs des substituants formés par un atome d'halogène, un groupe alkyle en $C_1$ à $C_{18}$, alcényle en $C_3$ à $C_{12}$, alcoxy en $C_1$ à $C_{12}$allyloxy, phénoxy, allkylthio en $C_1$ à $C_{18}$, allylthio, hydroxy-2 éthylthio, phénylthio, tolylthio, alkylamino en $C_1$ à $C_{12}$, dialkylamino en $C_2$ à $C_{24}$, bis(hydroxyalkyle en $C_4$ à $C_8$)-amino, diallylamino, bis(méthoxy-2 éthyl)-amino, morpholino, pipéridino ou pyrrolidino,

$R_1$ et $R_2$ représentent chacun, indépendamment l'un de l'autre, un groupe alkyle en $C_1$ à $C_8$ ou un groupe alkyle en $C_1$ à $C_4$ (substitué par un groupe -OH, alcoxy en $C_1$ à $C_4$, benzyloxy, -CN, -COO (alkyle en $C_1$ à $C_8$), (alkyl en $C_1$ à $C_4$)-COO-, dialkylamino en $C_2$ à $C_8$ ou morpholino), ou bien $R^1$ et $R^2$ forment ensemble un groupe alcanediyle en $C_3$ à $C_9$, oxa- ou aza-alcanediyle en $C_3$ à $C_9$ ou alcénediyle en $C_5$ à $C_9$,

X représente un groupe $-OR^3$ ou $-NR^4R^5$,

$R^3$ représente un atome d'hydrogène, un groupe allyle en $C_1$ à $C_8$, un groupe alkyle en $C_2$ à $C_4$ -(substitué par de l'halogène, par un groupe -OH ou alcoxy en $C_1$ à $C_4$), un groupe allyle, benzyle, tétrahydropyrranyle-2, triméthylsilyle ou phényl-diméthylsilyle,

$R^4$ et $R^5$ représentent chacun, indépendamment l'un de l'autre, un atome d'hydrogène, un groupe alkyle en $C_1$ à $C_{12}$, un groupe alkyle en $C_2$ à $C_4$ (substitué par un groupe -OH, alcoxy en $C_1$ à $C_4$, -CN ou -COO (alkyle en $C_1$ à $C_4$), un groupe allyle, benzyle ou cyclohexyle, ou bien $R^4$ et $R^5$ forment ensemble un groupe alkylène en $C_3$ à $C_7$, qui peut être interrompu par -O- ou $-N(R^6)-$, le symbole $R^6$ représentant un atome d'hydrogène, un groupe alkyle en $C_1$ à $C_4$, allyle, benzyle ou hydroxyalkyle en $C_2$ à $C_4$ ; et

B) 0,1 à 30 % en poids d'au moins un titanocène photo-amorceur, choisi parmi :

$B_1$) des composés de formule II :

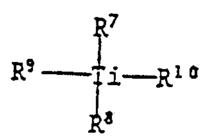

(II)

dans laquelle $R^7$ et $R^8$ représentent chacun, indépendamment l'un de l'autre, un anion cyclopentadiényle ou indényle (non substitué ou substitué par un groupe alkyle en $C_1$ à $C_4$, chloro, phényle ou cyclohexyle, ou bien $R^7$ et $R^8$ forment ensemble un anion bis-cyclopentadiényle divalent de formule III :

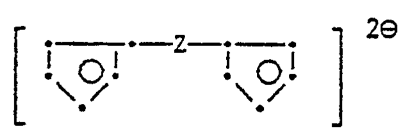

(III)

dans laquelle Z représente un groupe méthylène, diméthylène ou triméthylène, alkylidène en $C_2$ à $C_{12}$ cycloalkylidène en $C_5$ à $C_7$, $-Si(R^{11})(R^{12})-$ ou $-Sn(R^{11})_2-$, et

$R^{11}$ et $R^{12}$ représentent chacun un groupe alkyle en $C_1$ à $C_{12}$, phényle ou benzyle,

$R^9$ représente le reste monovalent d'un noyau aromatique carbocyclique hexagonal ou hétérocyclique pentagonal ou hexagonal, qui est substitué par du fluor au moins sur une position en ortho par rapport à la liaison avec l'atome de Ti et, en outre, peut être substitué par un ou plusieurs des substituants halogéno, alkyle en $C_1$ à $C_{12}$, alcoxy en $C_1$ à $C_{14}$, $-O(CH_2CH_2O)_{1-20}$ alkyle en $C_1$ à $C_{14}$, alcoxy (en $C_2$ à $C_{10}$)-carbonyle, aminocarbonyle ayant jusqu'à 12 atomes de carbone, ou par un groupe amino ou aminoalkyle primaire, secondaire ou tertiaire comportant jusqu'à 20 atomes de carbone ou par un groupe ammonium ou ammoniun-alkyle quaternaire ayant jusqu'à 30 atomes de carbone,

$R^{10}$ a l'un des sens indiqués pour $R^9$ ou représente un groupe alcynyle en $C_2$ à $C_{12}$, un groupe phénylalcynyle ayant 2 à 5 atomes de carbone dans le reste alcine, non substitué ou substitué dans le

reste phényle par de l'halogène ou par un groupe alkyle en $C_1$ à $C_{14}$, ou $R^{10}$ représente un atome d'halogène ou un groupe $-Si(R^{11})_3$, $-Si(R^{11})_2(R^{12})$, $-Sn(R^{11})_3$, -OH, un groupe alcoxy en $C_1$ à $C_{10}$, aryloxy en $C_6$ à $C_{10}$, acyloxy en $C_2$ à $C_6$ (non substitué ou substitué par de l'halogène, $-N\ ^3$, -CN, -NCO ou -NCS, ou bien

$R^9$ et $R^{10}$ forment ensemble un reste de formule -Q-Y-Q-, dans laquelle Q représente un noyau aromstique carbocyclique ou hétérocyclique pentagonal ou hexagonal, qui est fixé sur l'atome de titane en position 2 par rapport au groupe Y et est substitué par du fluor en position 3 et, qui peut comporter comme autre substituant un groupe alkyle en $C_1$ à $C_4$, halogéno, alcoxy en $C_1$ à $C_4$, di(alkyl) en $C_1$ à $C_4$)-amino ou un groupe ammonium quaternaire en $C_3$ à $C_{20}$,

Y représente un groupe méthylène, alkylidène en $C_2$ à $C_{12}$, cycloalkylidène en $C_5$ à $C_7$, une liaison directe ou un groupe $-NR^{13}$-, -O-, -S-, -SO-, $-SO_2$-, -CO-, $-Si(R^{11})-(R^{12})$- ou $-Sn(R^{11})_2$-, et $R^{13}$ représente un atome d'hydro$(R^{12})$- ou $-Sn(R^{11})_2$-, et $R^{13}$ représente un atome d'hydrogène, un groupe alkyle en $C_1$ à $C_{12}$, cyclohexyle, phényle, tolyle ou benzyle, ou

$B_2$) des composés de formule IV :

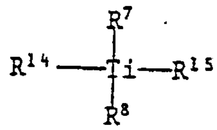

(IV)

dans laquelle $R^7$ et $R^8$ ont le sens précité,

$R^{14}$ représente le reste monovalent d' un noyau aromatique carbocyclique hexagonal ou hétérocyclique pentagonal ou hexagonal qui est substitué par $-CF_3$ sur au moins une position en ortho par rapport à la liaison avec l'atome de Ti et qui peut être substitué en outre par un ou plusieurs substituants choisis parmi un groupe halogéno, alkyle en $C_1$ à $C_{12}$, alcoxy en $C_1$ à $C_{14}$, $-O(CH_2CH_2O)_{1-20}$ alkyle en $C_1$ à $C_{14}$, alcoxy (en $C_2$ à $C_{10}$)-carbonyle ou aminocarbonyle ou par un groupe amino ou aminoalkyle primaire, secondaire ou tertiaire ayant jusqu'à 20 atomes de carbone ou par un groupe ammonium ou ammonium-alkyle quaternaire ayant jusqu'à 30 atomes de carbone, et

$R^{15}$ a l'un des sens indiqués pour $R^{14}$ ou représente un groupe alcynyle en $C_2$ à $C_{12}$, un groupe phénylalcynyle ayant 2 à 5 atomes de carbone dans le reste alcine (non substitué ou substitué dans le reste phényle par de l'halogène ou par un groupe alkyle en $C_1$ à $C_4$), ou $R^{15}$ représente un atome d'halogène ou un groupe $-Si(R^{11})3$, $-Si(R^{11})_2(R^{12})$, $-Sn(R^{11})_3$, -OH, alcoxy en $C_1$ à $C_{10}$, aryloxy en $C_6$ à $C_{10}$, acyloxy en $C_2$ à $C_6$, (non substitué ou substitué par de l'halogène), $-N_3$, -CN, -NCO ou -NCS.

**2.** Mélange liquide d' amorceurs selon la revendication 1, consistant en :

A) 80 à 99,5 % en poids d'un photo-amorceur liquide ou d'un mélange liquide de photo-amorceurs contenant au moins un composé de formule I, dans laquelle :

Ar représente un groupe phényle (non substitué ou substitué par un ou deux des substituants halogéno, alkyle en $C_1$ à $C_{12}$, alcoxy en $C_1$ à $C_8$, allyloxy, phénoxy, alkylthio en $C_1$ à $C_8$, hydroxy-2 éthylthio, allylthio, phénylthio, alkyl (en $C_1$ à $C_8$)-amino, dialkyl (en $C_2$ à $C_{16}$)-amino, diallylamino, bis-(hydroxyalkyl en $C_4$ à $C_6$)-amino, bis(méthoxy-2 éthyl)-amino, morpholino, pipéridino ou pyrrolidino),

$R^1$ et $R^2$ représentent, indépendamment l'un de l'autre, chacun un groupe alkyle en $C_1$ à $C_6$, un groupe alkyle en $C_1$ à $C_4$ (substitué par un groupe -OH, alcoxy en $C_1$ à $C_4$, benzyloxy, -COO (alkyle en $C_1$ à $C_4$), dialkyl (en $C_2$ à $C_4$)-amino ou morpholino), ou bien

$R^1$ et $R^2$ forment ensemble un groupe alcanediyle en $C_3$ à $C_6$ ou alcènediyle en $C_5$ à $C_7$,

X représente un groupe $-OR_3$ ou $-NR^4R^5$,

$R^3$ représente un atome d'hydrogène, un groupe alkyle en $C_1$ à $C_4$, un groupe alkyle en $C_2$ à $C_4$ -(substitué par -OH ou par un groupe alcoxy en $C_1$ à $C_4$), allyle, benzyle, tétrahydropyrranyle-2 ou triméthysilyle, et

$R^4$ et $R^5$ représentent chacun, indépendamment l'un de l'autre, un atome d'hydrogène, un groupe alkyle en $C_1$ à $C_8$, un groupe alkyle en $C_2$ à $C_4$ (substitué par -OH ou par un groupe alcoxy en $C_1$ à $C_4$), un groupe allyle, benzyle ou cyclohexyle, ou bien

$R^4$ et $R^5$ forment ensemble un groupe alkylène en $C_3$ à $C_7$, qui peut être interrompu par -O- ou $-N(R^6)$-, le symbole $R^6$ représentant un atome d'hydrogène, un groupe méthyle ou un groupe hydroxyalkyle en $C_2$ à $C_4$, et

B) 0,5 à 20 % en poids d'un composé de formule II, dans laquelle

$R^7$ et $R^8$ représentent chacun un anion cyclopentadiényle, non substitué ou substitué par un

groupe alkyle en $C_1$ à $C_4$, et

$R^9$ et $R^{10}$ représentent un groupe de formule V :

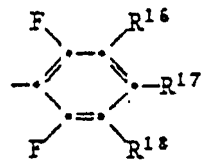

(V)

dans laquelle :

$R^{16}$, $R^{17}$ et $R^{18}$ représentent chacun, indépendamment l' un de l' autre, un atome d' hydrogène, de F, de Cl, de Br, un groupe alcoxy en $C_1$ à $C_{14}$, -O-($CH_2CH_2O$)$_{1-8}$ alkyle en $C_1$ à $C_{14}$, un groupe amino tertiaire ou un groupe amino méthyle ayant 2 à 20 atomes de carbone ou un groupe ammonium ou anmonium-méthyle quaternaire comportant 3 à 24 atomes de carbone, ou

$R^9$ et $R^{10}$ forment ensemble un groupe divalent de formule :

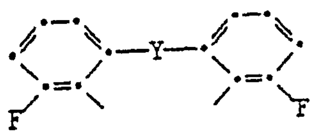

dans laquelle Y a le sens indiqué à la revendicstion 1, ou bien 0,5 à 20 % en poids d'un composé de formule IV, dans laquelle $R^7$ et $R^8$ représentent un anion cyclopentadiényle (non substitué ou substitué par un groupe alkyle en $C_1$ à $C_4$) et $R^{14}$ représente un groupe de formule VI :

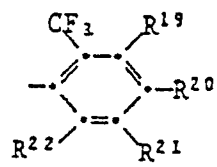

(VI)

dans laquelle $R^{19}$, $R^{20}$, $R^{21}$ et $R^{22}$ représentent chacun, indépendamment l'un de l'autre, un atome d'hydrogène, de F, de Cl, de Br ou un groupe alcoxy en $C_1$ à $C_{14}$, et $R^{15}$ a l'un des sens indiqués pour $R^{14}$ ou représente F, Cl, -Br, CN, -O-CO-$CH_3$, -O-CO-$CF_3$, $N_3$, -NCO ou -NCS.

**3.** Mélange liquide d' amorceurs selon la revendication 1, caractérisé en ce que le constituant A est un mélange liquide d'un composé de formule I et d'un composé de formule VII :

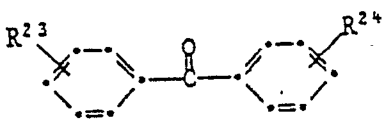

(VII)

dans laquelle $R^{23}$ et $R^{24}$ représentent chacun, indépendamment l'un de l'autre, un atome d,hydrogène, un groupe alkyle en $C_1$ à $C_{12}$, alcoxy en $C_1$ à $C_4$, alkylthio en $C_1$ à $C_4$, hydroxyalkyloxy en $C_2$ à $C_4$, hydroxyalkylthio en $C_2$ à $C_4$, halogéno, alcoxycarbonyle en $C_2$ à $C_{10}$ ou dialkylamino en $C_2$ à $C_8$.

**4.** Mélange liquide d'amorceurs selon la revendication 3, dans lequel les composés de formule I et de formule VII sont présents selon un rapport pondéral de 0,8:l à 1:0,8.

**5.** Mélange liquide d'amorceurs selon la revendication 1, caractérisé en ce que le constituant A est un mélange liquide d'un composé de formule I et d'une tri(alkyl en $C_1$ à $C_4$)-2,4,6 benzophénone.

**6.** Mélange liquide d'amorceurs selon la revendication 1, caractérisé en ce que le constituant A est un mélange liquide d'un composé de formule I et d'un composé de formule VIII :

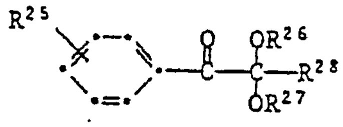

(VIII)

dans laquelle $R^{25}$ représente un atome d'halogène, un groupe alkyle en $C_1$ à $C_4$ ou alcoxy en $C_1$ à $C_4$ ;

$R^{26}$ et $R^{27}$ représentent chacun un groupe alkyle en $C_1$ à $C_6$, alcényle en $C_2$ à $C_4$, phénylalkyle en $C_7$ à $C_{10}$ ou un groupe alkyle en $C_2$ à $C_4$ (substitué par de l'halogène, par un groupe alcoxy en $C_1$ à $C_4$, dialkylamino en $C_2$ à $C_8$, morpholino ou pipéridino), ou bien $R^{26}$ et $R^{27}$ forment ensemble un groupe alcanediyle en $C_2$ à $C_{12}$ ou butène-2 diyle-1,4 et

$R^{28}$ représente un atome d'hydrogène, un groupe alkyle en $C_1$ à $C_8$, cycloalkyle en $C_5$ à $C_8$, phényle, ou bien un groupe phényle (substitué par de l'halogène, par un groupe alkyle en $C_1$ à $C_4$ ou alcoxy en $C_1$ à $C_4$).

**7.** Mélange liquide d' amorceurs selon la revendication 6, dans lequel les composés de formule I et de formule VIII sont présents selon un rapport pondéral de 2:1 à 1:2.

**8.** Mélange liquide d'amorceurs selon la revendication 1, caractérisé en ce que le constituant A est un mélange liquide d'un composé de formule I, d'un composé de formule VII et d'un composé de formule VIII.

**9.** Mélange liquide d'amorceurs selon la revendication 1, caractérisé en ce que le constituant A contient un composé de formule I, dans laquelle Ar représente un groupe phényle, ou bien un groupe phényle (substitué par du chlore, du fluor, un groupe alkyle en $C_1$ à $C_{12}$, méthoxy, méthylthio, diméthylamino, diéthylamino, bis(méthoxy-2 éthyl)-amino, morpholino, pipéridino ou pyrrolidino,

$R^1$ et $R^2$ représentent chacun, indépendamment l'un de l'autre, un groupe alkyle en $C_1$ à $C_4$ ou un groupe alkyle en $C_1$ à $C_4$ (substitué par -CH ou par un groupe alcoxy en $C_1$ à $C_4$) ou bien

$R^1$ et $R^2$ forment ensemble un groupe alcanedíyle en $C_4$ à $C_6$ ou alcènediyle en $C_5$ à $C_7$

et X représente -OH ou $-NR^4R^5$, formule dans laquelle $R^4$ et $R^5$ représentent chacun un groupe alkyle en $C_1$ à $C_4$, allyle ou méthoxy-2 éthyle, ou bien $R^4$ et $R^5$ forment, avec l'atome d'azote, un groupe pyrrolidino, pipéridino, morpholino, pipérazino ou méthyl-4 pipérazino.

**10.** Mélange liquide d'amorceurs selon la revendication 1, caractérisé en ce que le constituent A contient un composé de formule I, dans laquelle Ar représente un groupe phényle, p-tolyle, p-cumyle, dodécyl-4 phényle, chloro-4 phényle ou méthoxy-4 phényle ; $R^1$ et $R^2$ représentent chacun,- indépendamment l'un de l'autre, un groupe alkyle en $C_1$ à $C_4$ ou bien $R^1$ et $R^2$ forment ensemble un groupe tétraméthyléne ou pentaméthylène, et X représente un groupe hydroxyle.

**11.** Mélange liquide d'amorceurs selon la revendication 1, caractérisé en ce que le constituant A contient un composé de formule I, dans laquelle Ar représente un groupe phényle, p-tolyle, p-cumyle, chloro-4 phényle, méthoxy-4 phényle, méthylthio-4 phényle, diméthylamino-4 phényle, diéthylamino-4 phényle, bis(méthoxy-2 éthyl)-amino-4 phényle, morpholino-4 phényle ou pipéridino-4 phényle ; $R^1$ et $R^2$ représentent chacun, indépendamment l'un de l'autre, un groupe alkyle en $C_1$ à $C_4$, et X représente un groupe méthylamino, diméthylamino, éthylamino, diéthylamino, bis(méthoxy-2 éthyl)-amino, pipéridino, pyrrolidino, morpholino, pipérazino ou méthyl-4 pipérazino.

**12.** Mélange liquide d'amorceurs selon la revendication 1, caractérisé en ce que le constituant B est un composé de formule II, dans laquelle $R^7$ et $R^8$ représentent chacun un anion cyclopentadiényle ou méthylcyclopentadiényle, et $R^9$ et $R^{10}$ représentent chacun un groupe de formule V, le symbole $R^{16}$ représentant H, F, Cl ou Br, $R^{17}$ représentant un atome de fluor, un groupe alcoxy en $C_1$ à $C_{14}$ ou $-O-(CH_2CH_2O)_{1-6}$ alkyle en $C_1$ à $C_{14}$, et $R^{18}$ représente H, Cl ou Br, ou bien b) $R^{18}$ représente H, F, Cl ou Br et $R^{16}$ et $R^{17}$ représentent chacun H, Cl, Br, un groupe alcoxy en $C_1$ à $C_{14}$, $-O(CH_2CH_2O)_{1-6}$ alkyle en $C_1$ à $C_{14}$, un groupe amino ou amino-méthyle tertiaire ou un groupe ammonium ou ammonium-méthyle quaternaire, ou bien B représente un composé de formule IV, dans laquelle $R^7$ et $R^8$ représentent chacun un anion cyclopentadiényle ou méthylcyclopentadiényle, $R^{14}$ représente un groupe (trifluorométhyl)-2 phényle ou fluoro-6 (trifluorométhyl)-2 phényle, et $R^{15}$ a le même sens que

$R^{14}$ ou représente F, Cl, Br, CN, $N_3$, $-O-CO-CH_3$, $-O-CO-CF_3$, -NCO ou -NCS.

**13.** Mélange liquide d'amorceurs selon la revendication 3, caractérisé en ce que le constituant A est un mélange liquide d'un composé de formule I et de la benzophénone.

**14.** Mélange liquide d'amorceurs selon la revendication 1, caractérisé en ce que le constituant A est un mélange liquide d'un composé de formule I et de la diméthoxy-2,2 phényl-2 acétophénone ou de la diéthoxy-2,2 phényl-2 acétophénone.

**15.** Mélange liquide d'amorceurs selon la revendication 1, consistant en :
40 à 50 % en poids de l'hydroxy-1 cyclohexylphényl cétone,
40 à 50 % en poids de la benzophénone, et
2 à 20 % en poids d'un composé de formule II ou IV.

**16.** Mélange liquide d'amorceurs selon la revendication 15, consistant en :
40 à 50 % en poids de l'hydroxy-1 cyclohexylphényl cétone,
40 à 50 % en poids de la benzophénone, et
2 à 20 % en poids de bis(cyclopentadiényl)-bis(décyloxy-4)-tétrafluorophényl-titane.

**17.** Mélange liquide d'amorceurs selon la revendication 1, consistant en :
25 à 30 % en poids de l'hydroxy-1 cyclohexylphényl cétone,
25 à 30 % en poids de la benzophénone,
35 à 40 % en poids de la diméthyloxy-2,2 phényl-2 acétophénone, et
2 à 15 % en poids d'un composé répondant à la formule II ou à la formule IV.

**18.** Composition photodurcissable, contenant au moins un composé à insaturation éthylénique et 0,5 à 20 % en poids d'un mélange d'amorceurs selon la revendication 1.

**19.** Composition photodurcissable selon la revendication 18, caractérisée en ce que la composition est une laque ou un vernis ou est une encre d'impression.

**20.** Composition photodurcissable selon la revendication 18, caractérisée en ce que la composition est une matière pour préparer des plaques d'impression, des matières pour réserve, des matières pour la formation d'images ou d'autres supports d'information.

**21.** Composition photodurcissable selon la revendication 20, caractérisée en ce que la formation d'images a lieu dans une matière de réserve ou pour plaques d'impression directement à l'aide d'un rayon laser commandé ou programmé.